# EUROPEAN PATENT APPLICATION

(11) **EP 4 797 662 A1**
(43) Date of publication of application: **26.08.2026**
(21) Application number: 24893334.3
(22) Date of filing: 15.11.2024
(51) Int. Cl.: H04L 69/04

(54) **DATA COMPRESSION METHOD, DATA DECOMPRESSION METHOD, AND RELATED APPARATUSES**

(30) Priority: 22.11.2023 CN 202311572613
(71) Applicant: HUAWEI TECHNOLOGIES CO., LTD., Shenzhen 518129 (CN)
(72) Inventor: TANG, Zihan, Shenzhen, Guangdong 518129 (CN); MA, Mengyao, Shenzhen, Guangdong 518129 (CN); PENG, Xiaohui, Shenzhen, Guangdong 518129 (CN); LIU, Kai, Shenzhen, Guangdong 518129 (CN)
(74) Representative: Gill Jennings & Every LLP
(86) International application number: PCT/CN2024/132150
(87) International publication number: WO 2025/108176

(57) **Abstract**

This application provides a data compression method and a compression apparatus. The compression apparatus segments raw data based on feature information of the raw data and compresses the raw data separately to achieve a larger compression ratio. This application further provides a data decompression method and a decompression apparatus. The decompression apparatus obtains compressed data and first information, and restores a groups of segmented data to the raw data based on the first information. Therefore, even if the compression apparatus segments the raw data, the decompression apparatus can quickly and efficiently restore the compressed data to the raw data based on the first information.

## Description

This application claims priority to Chinese Patent Application No. 202311572613.8, filed with the China National Intellectual Property Administration on November 22, 2023 and entitled "DATA COMPRESSION METHOD, DATA DECOMPRESSION METHOD, AND RELATED APPARATUS", which is incorporated herein by reference in its entirety.

### TECHNICAL FIELD

Embodiments of this application relate to the field of data compression, and in particular, to a data compression method, a data decompression method, and a related apparatus.

### BACKGROUND

Data compression (Data Compression) is a technique for reorganizing data using a specific algorithm to reduce data redundancy while preserving useful information, enabling data transmission with fewer resources.

However, directly compressing large data volumes makes it difficult to identify a suitable compression algorithm and may compromise compression efficiency.

### SUMMARY

This application provides a data compression method and a compression apparatus. The method involves identifying features conducive to compression in raw data, and segmenting and grouping data with similar features for compression, to achieve better compression performance. In addition, this application further provides a data decompression method and a decompression apparatus for restoring compressed data to raw data.

According to a first aspect, this application provides a data compression method. The data compression method may be performed by a compression apparatus, or may be performed by a component (for example, a component like a processor, a chip, or a chip system) of the compression apparatus. The compression apparatus is used as an example. The compression apparatus segments raw data based on feature information of the raw data, and outputs first information and a groups of segmented data, where each group of segmented data includes at least one data block, data blocks included in any two groups of segmented data are different, the first information indicates a segmentation manner of segmenting the raw data into the a groups of segmented data, and a is an integer greater than 1. Then, the compression apparatus separately compresses the a groups of segmented data, and outputs a groups of compressed data.

In this application, the compression apparatus segments the raw data based on the feature information of the raw data, outputs the first information and the a groups of segmented data, and then separately compresses the a groups of segmented data into the a groups of compressed data. Because the compression apparatus first segments the raw data based on the feature information of the raw data, and then separately compresses, a larger compression ratio is obtained, and transmission resources occupied during transmission are reduced. The first information to be sent to the decompression apparatus is output, so that the decompression apparatus can accurately and efficiently restore the a groups of compressed data to the raw data, and data transmission efficiency is improved.

In a possible implementation, the feature information of the raw data includes at least one of the following:
correlation information between at least two data blocks included in the raw data, or physical meaning information of at least one data block included in the raw data.

In a possible implementation, data blocks in a same group of segmented data have a same physical meaning, and data blocks in different groups of segmented data have different physical meanings.

In this implementation, the raw data is segmented based on a feature (for example, a correlation or a physical meaning) that is conducive to data compression in the raw data, and data that has a strong correlation or has a same physical meaning is grouped into a same group for compression, so that redundancy hidden in the data can be more fully exploited, and data compression efficiency is improved.

In a possible implementation, the method further includes: The compression apparatus sends the first information and the a groups of compressed data. For example, the compression apparatus sends the first information and the a groups of compressed data to the decompression apparatus. The first information is used by the decompression apparatus to determine the raw data based on each data block in the a groups of segmented data.

In this implementation, the compression apparatus sends both the a groups of compressed data and the first information to the decompression apparatus, so that the decompression apparatus can quickly and accurately obtain the raw data based on the first information and the a groups of segmented data obtained through decompression, and data decompression efficiency is improved.

In a possible implementation, the first information includes first indication information, where the first indication information indicates a position, in the raw data, of a data block included in at least (a-1) groups of segmented data.

In this implementation, the compression apparatus sends the first indication information to the decompression apparatus, where the first indication information can indicate the position, in the raw data, of the data block included in the at least (a-1) groups of segmented data, so that the decompression apparatus derives the a groups of segmented data based on the (a-1) groups of segmented data and the first indication information, to restore the raw data, and efficiency of restoring the raw data by the decompression apparatus is improved.

In a possible implementation, the first information further includes second indication information, or the compression apparatus sends second indication information through other signaling. The second indication information indicates a compression manner of the first indication information.

Optionally, the second indication information includes any one of the following: a lexicographical order indication, an arithmetic coding indication, a direct indication, or a bit map indication.

In this implementation, the first indication information sent by the compression apparatus to the decompression apparatus is compressed, so that transmission overheads occupied for transmitting the first indication information are reduced. In addition, the compression apparatus indicates, to the decompression apparatus through the second indication information, the compression manner of the first indication information, so that the decompression apparatus accurately decompresses the first indication information, and efficiency of restoring the raw data by the decompression apparatus is improved.

In a possible implementation, the second indication information includes the lexicographical order indication, the first indication information includes first compression information and second compression information, the first compression information indicates a lexicographical order of numbers of data blocks included in one piece of segmented data, and the second compression information indicates a quantity of data blocks included in one group.

In this implementation, the first indication information uses lexicographical ordering. Because each numbered group corresponds to a specific combination scheme, a quantity of data blocks in the numbered group is indicated first, followed by the subscript of the combination scheme in the lexicographical order of all combination schemes that select a same quantity of data blocks. This approach uses fewer bits to indicate data blocks included in a group, reducing bit overheads of the first indication information.

In a possible implementation, the data block includes a plurality of data elements. Before or after the segmentation, the compression apparatus further performs the following step: The compression apparatus reorders a plurality of data elements in at least one data block, and outputs at least one data block after the reordering.

The reordering refers to switching positions of at least two data elements in the at least one data block. Optionally, the data block may be at least one column of data, or may be at least one row of data, or may be a plurality of data elements. This is not limited herein.

Optionally, the compression apparatus may reorder data blocks in the raw data or data blocks in the segmented data. In an example, the reordering is configured before the segmentation. In other words, the compression apparatus first reorders at least two data elements in the raw data based on the feature information of the raw data, and then segments the reordered data. In another example, the reordering is configured after the segmentation. In other words, the compression apparatus first groups the raw data based on the feature information of the raw data, and then reorders at least two data elements in at least one piece of segmented data.

In this implementation, after the reordering, a distance between the at least two data blocks can be reduced, and a correlation between the at least two data blocks can be improved, so that joint compression is subsequently performed on the at least two data blocks, and subsequent compression performance is improved.

In a possible implementation, the first information further includes third indication information, or the compression apparatus sends third indication information through other signaling. The third indication information indicates a position relationship between the data elements in the data block after the reordering and the data elements in the data block before the reordering.

In this implementation, the compression apparatus sends the third indication information to the decompression apparatus, so that the decompression apparatus determines, based on the data block after the reordering, the data block before the reordering, and efficiency of restoring the raw data by the decompression apparatus is improved.

In a possible implementation, the first information further includes fourth indication information, or the compression apparatus sends fourth indication information through other signaling. The fourth indication information indicates a compression manner of the third indication information. Optionally, the fourth indication information includes either one of the following: an arithmetic coding indication or a direct indication.

In this implementation, the third indication information sent by the compression apparatus to the decompression apparatus is compressed, so that transmission overheads occupied for transmitting the third indication information are reduced. In addition, the compression apparatus indicates, to the decompression apparatus through the fourth indication information, the compression manner of the third indication information, so that the decompression apparatus accurately decompresses the third indication information, and efficiency of restoring the raw data by the decompression apparatus is improved.

In a possible implementation, the segmentation manner includes any one of the following: segmenting and reassembling by row; or segmenting and reassembling by column; or segmenting and reassembling first by row and then by column; or segmenting and reassembling first by column and then by row.

In this implementation, a plurality of possible segmentation manners are provided, to implement diversity of data segmentation.

According to a second aspect, this application provides a data decompression method. The data decompression method may be performed by a decompression apparatus, or may be performed by a component (for example, a component like a processor, a chip, or a chip system) of the decompression apparatus. The decompression apparatus is used as an example. The decompression apparatus obtains first information and a groups of compressed data, where a is an integer greater than 1. Then, the decompression apparatus separately decompresses the a groups of compressed data, to obtain a groups of segmented data, where each group of segmented data includes at least one data block, and data blocks included in any two groups of segmented data are different. Then, the decompression apparatus determines raw data based on the first information and the a groups of segmented data, where the first information indicates a segmentation manner of segmenting the raw data into the a groups of segmented data.

In this application, the decompression apparatus obtains the a groups of compressed data and the first information, where the first information indicates the segmentation manner of segmenting the raw data into the a groups of segmented data, so that the decompression apparatus restores, to the raw data based on the first information, the a groups of segmented data obtained through decompression. Therefore, even if the compression apparatus segments the raw data, the decompression apparatus can quickly and efficiently restore the compressed data to the raw data based on the first information, so that data decompression efficiency is improved.

In a possible implementation, the first information includes first indication information, where the first indication information indicates a position, in the raw data, of a data block included in at least (a-1) groups of segmented data.

In a possible implementation, the first information further includes second indication information, or the decompression apparatus receives second indication information through other signaling. The second indication information indicates a compression manner of the first indication information.

In a possible implementation, the second indication information includes any one of the following: a lexicographical order indication, an arithmetic coding indication, a direct indication, or a bit map indication.

In a possible implementation, the second indication information includes the lexicographical order indication, the first indication information includes first compression information and second compression information, the first compression information indicates a lexicographical order of numbers of data blocks included in one piece of segmented data, and the second compression information indicates a quantity of data blocks included in one group.

In a possible implementation, the data block includes a plurality of data elements, and the first information further includes third indication information, or the decompression apparatus receives third indication information through other signaling. The third indication information indicates a position relationship between the data elements in the data block after the reordering and the data elements in the data block before the reordering.

The method further includes: The decompression apparatus determines, based on the third indication information, the data block before the reordering.

In a possible implementation, the first information further includes fourth indication information, or the decompression apparatus receives fourth indication information through other signaling. The fourth indication information indicates a compression manner of the third indication information.

In a possible implementation, the fourth indication information includes either one of the following: an arithmetic coding indication or a direct indication.

In a possible implementation, the segmentation manner includes any one of the following:
segmenting and reassembling by row; or segmenting and reassembling by column; or segmenting and reassembling first by row and then by column; or segmenting and reassembling first by column and then by row.

In a possible implementation, the segmented data is data obtained by segmenting the raw data based on feature information of the raw data; and the feature information of the raw data includes at least one of the following: correlation information between at least two data blocks included in the raw data, or physical meaning information of at least one data block included in the raw data.

In a possible implementation, data blocks in a same group of segmented data have a same physical meaning, and data blocks in different groups of segmented data have different physical meanings.

It should be noted that specific implementations and beneficial effect of this aspect are similar to a part of implementations of the first aspect. For details, refer to the specific implementations and beneficial effect of the first aspect. Details are not described herein.

According to a third aspect, an embodiment of this application provides an apparatus. The apparatus may be the compression apparatus in the foregoing implementations, or may be a chip in the compression apparatus. The apparatus may include a processing module and a transceiver module. When the apparatus is a compression apparatus, the processing module may be a processor, and the transceiver module may be a transceiver. The compression apparatus may further include a storage module, and the storage module may be a memory. The storage module is configured to store instructions, and the processing module executes the instructions stored in the storage module, so that the compression apparatus performs the method according to the first aspect or any one of the implementations of the first aspect. When the apparatus is a chip in the compression apparatus, the processing module may be a processor, and the transceiver module may be an input/output interface, a pin, a circuit, or the like. The processing module executes the instructions stored in the storage module, so that the compression apparatus performs the method according to the first aspect or any one of the implementations of the first aspect. The storage module may be a storage module (for example, a register or a cache) in the chip, or may be a storage module (for example, a read-only memory or a random-access memory) that is in the compression apparatus and that is located outside the chip.

According to a fourth aspect, an embodiment of this application provides an apparatus. The apparatus may be the decompression apparatus in the foregoing implementations, or may be a chip in the decompression apparatus. The apparatus may include a processing module and a transceiver module. When the apparatus is a decompression apparatus, the processing module may be a processor, and the transceiver module may be a transceiver. The decompression apparatus may further include a storage module, and the storage module may be a memory. The storage module is configured to store instructions, and the processing module executes the instructions stored in the storage module, so that the first decompression apparatus performs the method according to the second aspect or any one of the implementations of the second aspect. When the apparatus is a chip in the decompression apparatus, the processing module may be a processor, and the transceiver module may be an input/output interface, a pin, a circuit, or the like. The processing module executes the instructions stored in the storage module, so that the first decompression apparatus performs the method according to the second aspect or any one of the implementations of the second aspect. The storage module may be a storage module (for example, a register or a cache) in the chip, or may be a storage module (for example, a read-only memory or a random-access memory) that is in the decompression apparatus and that is located outside the chip.

According to a fifth aspect, this application provides an apparatus. The apparatus may be an integrated circuit chip. The integrated circuit chip includes a processor. The processor is coupled to a memory. The memory is configured to store a program or instructions. When the program or the instructions are executed by the processor, the communication apparatus is enabled to perform the method according to any one of the implementations of the foregoing aspects.

According to a sixth aspect, an embodiment of this application provides a computer program product including instructions. When the computer program product runs on a computer, the computer is enabled to perform the method according to any one of the implementations of the foregoing aspects.

According to a seventh aspect, an embodiment of this application provides a computer-readable storage medium including instructions. When the instructions are run on a computer, the computer is enabled to perform the method according to any one of the implementations of the foregoing aspects.

According to an eighth aspect, an embodiment of this application provides a system. The system includes the compression apparatus that performs the first aspect and any one of the implementations of the first aspect, and the decompression apparatus that performs the second aspect and any one of the implementations of the second aspect.

### BRIEF DESCRIPTION OF DRAWINGS

FIG. 1 is a schematic flowchart of a data compression method according to this application;
FIG. 2 is an example diagram of raw data according to this application;
FIG. 3A is an example diagram of segmenting by row according to this application;
FIG. 3B is an example diagram of segmenting by column according to this application;
FIG. 3C is an example diagram of first segmenting by row and then segmenting by column according to this application;
FIG. 3D is an example diagram of first segmenting by column and then segmenting by row according to this application;
FIG. 4 is an example diagram of segmentation based on a physical meaning according to this application;
FIG. 5A is an example diagram of segmentation based on a clustering algorithm according to this application;
FIG. 5B is another example diagram of segmentation based on a clustering algorithm according to this application;
FIG. 6A is an example diagram of segmentation according to this application;
FIG. 6B is an example diagram of indicating first indication information in a lexicographical order indication manner according to this application;
FIG. 6C is an example diagram of indicating first indication information in a direct indication manner according to this application;
FIG. 6D is an example diagram of indicating first indication information in a one-dimensional bit map manner according to this application;
FIG. 6E is an example diagram of indicating first indication information in a two-dimensional bit map manner according to this application;
FIG. 7A is an example diagram of reordering according to this application;
FIG. 7B is another example diagram of reordering according to this application;
FIG. 8 is a schematic flowchart of a data decompression method according to this application;
FIG. 9 is a schematic flowchart of a data transmission method according to this application;
FIG. 10 is another schematic flowchart of a data transmission method according to this application;
FIG. 11 is a diagram of an embodiment of an apparatus according to this application; and
FIG. 12 is a diagram of another embodiment of an apparatus according to this application.

### DESCRIPTION OF EMBODIMENTS

The following clearly and completely describes technical solutions of embodiments of this application with reference to accompanying drawings in embodiments of this application. It is clear that the described embodiments are merely some but not all of embodiments of this application.

In the specification, claims, and accompanying drawings of this application, the terms "first", "second", "third", "fourth", and the like (if any) are intended to distinguish between similar objects but do not necessarily indicate a specific order or sequence. It should be understood that the terms termed in such a way is interchangeable in proper circumstances, so that embodiments described herein can be implemented in other orders than the order illustrated or described herein. In addition, the terms "include", "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

It should be understood that the term "and/or" in this specification describes only an association relationship between associated objects and represents that three relationships may exist. For example, A and/or B may represent the following three cases: Only A exists, both A and B exist, and only B exists. In addition, the character "/" in this specification generally indicates an "or" relationship between the associated objects. In addition, in this specification, "at least one of the following" or a similar expression thereof represents any combination of the listed items. For example, at least one of A, B, and (or) C may represent the following six cases: Only A exists, only B exists, only C exists, both A and B exist, both B and C exist, both A and C exist, and all A, B, and C exist. A, B, and C may be singular or plural.

The data compression method and the data decompression method provided in this application may be applied to a scenario in which complex data needs to be compressed. The data compression method and the compression apparatus are used to segment and reassemble raw data based on a feature of the raw data, to improve data compression efficiency. The data decompression method and the decompression apparatus are used to restore compressed data to complex raw data.

It should be understood that the method and the apparatus provided in this application may be applied to a scenario related to data compression in a communication system, or may be applied to a scenario related to data compression in another system. For example, the communication system may be an 5G NR (5G New Radio) system, a 6th generation mobile information technology (the 6th generation mobile communication technology, 6G) system, or a subsequent evolved standard. This is not limited in this application.

The communication system is used as an example. The data compression method and/or the data decompression method provided in this application may be applied to a communication apparatus. The compression apparatus and/or the decompression apparatus provided in this application may be a communication apparatus, or may be a component (for example, a processor, a chip, or a chip system) in the communication apparatus. The communication apparatus may be a terminal device, or may be an access network device. This is not limited in this application. For example, cellular network communication is used as an example. The communication apparatus mainly includes a terminal device and an access network device. For another example, proximity communication (proximity communication, PC5) is used as an example. The communication apparatus mainly includes a terminal device.

The terminal device includes a device that provides voice and/or data connectivity for a user. For example, the terminal device may include a handheld device having a wireless connection function, or a processing device connected to a wireless modem. In cellular network communication, the terminal device may communicate with a radio access network (radio access network, RAN) through a Uu interface, and communicate with a core network (for example, a 5G core network (5th generation core, 5GC)) through a RAN. Optionally, in a PC5 communication scenario, the terminal device supports a direct communication interface (namely, a PC5 interface), and can communicate, through the PC5 interface, with another terminal device that supports the PC5 interface. It should be understood that the terminal device may also be referred to as a terminal (Terminal), user equipment (user equipment, UE), a mobile terminal (mobile terminal, MT) device, a mobile station (mobile station, MS), a mobile console (mobile), a remote station (remote station), an access terminal device (access terminal), a user device (user device), or the like. In addition, the terminal device may be a mobile phone (mobile phone), a tablet computer (Pad), or a computer with a wireless transceiver function. In addition, the terminal device may be an internet of things (internet of things, IoT) terminal, and the IoT terminal has functions of data collection, data processing, and data transmission. For example, the IoT terminal periodically collects or triggers collection based on an event, performs a series of processing such as compression on collected data, and sends the collected data to the access network device or another IoT terminal. For example, the IoT terminal may be a wireless terminal in industrial control (industrial control), a wireless terminal in self-driving (self-driving), a wireless terminal in remote medical surgery (remote medical surgery), a wireless terminal in smart grid (smart grid), a wireless terminal in transportation safety (transportation safety), a wireless terminal in smart city (smart city), or a wireless terminal in smart home (smart home).

In addition, the access network device may be any device having a wireless transceiver function, and may be configured to be responsible for a function related to an air interface, for example, a radio link maintenance function, a radio resource management function, and some mobility management functions. In addition, the access network device may be further configured with a baseband unit (baseband unit, BBU), and has a baseband signal processing function. For example, the access network device may be an access network device (radio access network, RAN) that currently provides a service for the terminal device. Currently, some common examples of the access network device are a NodeB (NodeB, NB), an evolved NodeB (evolved NodeB, eNB or eNodeB), a next generation NodeB (next generation NodeB, gNB) in a 5G new radio (new radio, NR) system, a node (for example, an xNodeB) in a 6G system, a transmission reception point (transmission reception point, TRP), a radio network controller (radio network controller, RNC), a base station controller (base station controller, BSC), a base transceiver station (base transceiver station, BTS), and a home base station (for example, a home evolved NodeB (home evolved NodeB) or a home NodeB (home NodeB, HNB)). In addition, the access network device may include at least one of a central unit (central unit, CU) (also referred to as a control unit), a distributed unit (distributed unit, DU), and a radio unit (radio unit, RU). The RAN device including the CU and the DU separates protocol layers of a gNB in an NR system. Functions of some protocol layers are controlled by the CU in a centralized manner. Functions of some or all remaining protocol layers are distributed in the DU, and the CU controls the DU in a centralized manner.

It should be noted that if the method and the apparatus provided in this application are applied to a scenario related to data compression in a communication system, the compression apparatus and the decompression apparatus provided in this application may be integrated into different communication apparatuses, or may be integrated into different modules or units of a same communication apparatus.

For example, if the compression apparatus and the decompression apparatus are integrated into different communication apparatuses, a communication apparatus integrating the compression apparatus and a communication apparatus integrating the decompression apparatus may communicate with each other in a wireless manner or a wired manner, to transmit compressed data. For example, the compression apparatus and the decompression apparatus may be respectively integrated into an access network device and a terminal device, and the access network device and the terminal device may transmit compressed data through an air interface. For another example, the compression apparatus and the decompression apparatus may be respectively integrated into two terminal devices that perform communication through a PC5 communication interface, and compressed data is transmitted between the two terminal devices through the PC5 communication interface.

For example, if the compression apparatus and the decompression apparatus are integrated in different modules or units of a same communication apparatus, a module (or unit) integrating the compression apparatus and a module (or unit) integrating the decompression apparatus may communicate with each other through an internal interface of the communication apparatus, to transmit compressed data. For example, if the access network device has a CU-DU separation architecture, the compression apparatus and the decompression apparatus may be respectively integrated into a CU and a DU, and the CU and the DU transmit compressed data through an interface between the CU and the DU.

In addition, if the method and the apparatus provided in this application are applied to a scenario related to data compression in another system, the compression apparatus and the decompression apparatus may be integrated into different devices or apparatuses, or may be integrated into a same device or apparatus. This is not limited in this application.

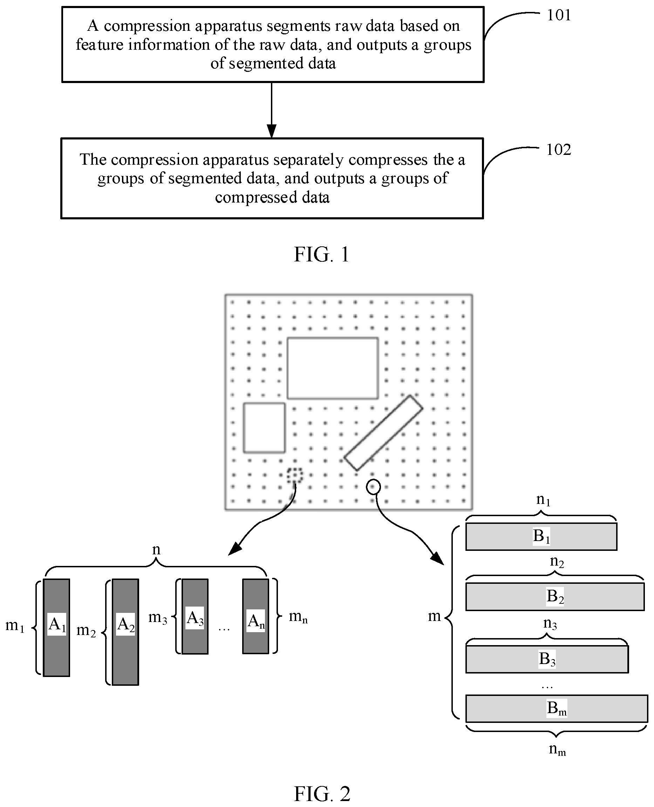

The following describes a main procedure of the data compression method provided in this application with reference to FIG. 1. The data compression method may be performed by a compression apparatus. The compression apparatus may be the apparatus (for example, a communication apparatus like a terminal device or an access network device) or a component (for example, a component like a processor, a chip, or a chip system) of the apparatus described above. The following uses the compression apparatus as an example for description. As shown in FIG. 1, the data compression method mainly includes the following steps.

Step 101: The compression apparatus segments raw data based on feature information of the raw data, and outputs a groups of segmented data.

The raw data is data that needs to be segmented. Optionally, the raw data may be data that is not suitable for being directly compressed in any scenario.

Optionally, the raw data in this application may be data generated by a communication apparatus in a communication system. For example, the raw data may be non-service data generated inside a communication apparatus in a wireless communication system. For example, the raw data may be physical layer data (for example, channel state information (channel state information, CSI) data) generated by the communication apparatus in a channel measurement process. For another example, the raw data may be measurement data or intermediate data generated by the communication apparatus in a sensing measurement process, for example, sensing data (sensing data) like RF map data and point cloud data. It should be understood that the raw data may alternatively be data generated by the communication apparatus in another measurement process. Examples are not enumerated herein. For ease of understanding, the RF map data shown in FIG. 2 is used as an example. The RF map data is a type of air interface native data that is highly related to geographical position information, and mainly describes electromagnetic propagation features of an environment. Generally, space is divided into grids based on a specific resolution, and each grid is represented by a position point (for example, a central point of the grid). Information related to an electromagnetic propagation environment at the position point is recorded as a data vector in the RF map data. The information related to the electromagnetic propagation environment includes an antenna angle, a delay, power, and other channel-related information. It can be learned that the RF map data includes data that describes an electromagnetic propagation feature of an environment, like an antenna angle, a delay, and power of at least one position. Therefore, the RF map data may be redundant, and a benefit may be obtained by segmenting the RF map data.

Optionally, the raw data may be data arranged by using a column vector as a basic unit, or may be data arranged by using a row vector as a basic unit. The following separately provides descriptions.

In a possible implementation, the raw data is arranged by using a column vector as a basic unit. That is, the raw data is segmented into at least one column vector by column. In other words, the raw data includes at least one column of data, and each column includes at least one data element. In an example, when the raw data includes at least two columns of data, lengths of data in different columns in the raw data may be completely equal. That is, quantities of data elements included in the columns of data in the raw data are all equal. Because the lengths of the columns of data in the raw data are equal and can be arranged into rectangular data, the raw data is matrix data. In another example, when the raw data includes at least two columns of data, lengths of data in different columns in the raw data are not completely equal. That is, a quantity of data elements included in one column of data in the raw data is not equal to a quantity of data elements included in another column of data in the raw data. In this case, the raw data is non-matrix data.

For example, as shown in FIG. 2, the raw data includes n columns, each represented by Aᵢ, represented as {A₁, A₂, A₃, ..., Aₙ}, where n is an integer greater than 1, and i is an integer greater than or equal to 1 and less than or equal to n. The column length is m₁ for a column A₁ (the column A₁ includes m₁ data elements), m₂ for a column A₂ (the column A₂ includes m₂ data elements), m₃ for a column A₃, and the others follow the same rule. If the lengths of the n columns are completely equal, that is, m₁=m₂=m₃=...=mₙ, the raw data is matrix data. If the lengths of the n columns are not completely equal, that is, m₁≠mᵢ (1<i≤n), the raw data is non-matrix data.

In another possible implementation, the raw data is arranged by using a column vector as a basic unit. That is, the raw data is segmented into at least one row vector by column. In other words, the raw data includes at least one row of data, and each row includes at least one data element. In an example, when the raw data includes at least two rows of data, lengths of data in different rows in the raw data may be completely equal. That is, quantities of data elements included in the rows of data in the raw data are all equal. Because the lengths of the rows of data in the raw data are equal and can be arranged into rectangular data, the raw data is matrix data. In another example, when the raw data includes at least two rows of data, lengths of data in different rows in the raw data are not completely equal. That is, a quantity of data elements included in one row of data in the raw data is not equal to a quantity of data elements included in another row of data in the raw data. In this case, the raw data is non-matrix data.

For example, as shown in FIG. 2, the raw data includes m rows, each represented by Bⱼ, represented as {B₁, B₂, B₃, ..., Bₘ}, where m is an integer greater than or equal to 1, and j is an integer greater than or equal to 1 and less than or equal to m. The row length is n₁ for a row B₁ (the row B₁ includes n₁ data elements), n₂ for a row B₂ (the row B₂ includes n₂ data elements), n₃ for a row B₃, and the others follow the same rule. If the lengths of the m rows are completely equal, that is, n₁=n₂=n₃=...=nₙ, the raw data is matrix data. If the lengths of the m rows are not completely equal, that is, n₁≠nᵢ (1<i≤m), the raw data is non-matrix data.

It should be understood that the raw data in this application may be any one of the foregoing implementations. This is not limited in this application.

Optionally, each group of segmented data includes at least one data block, and data blocks included in any two groups of segmented data are different. Optionally, a data block may be at least one column, at least one row, or at least one data element in the raw data. Depending on the segmentation manner, the form of the data block varies. The segmentation manner includes any one of the following: segmenting and reassembling by row; segmenting and reassembling by column; segmenting and reassembling first by row and then by column; or segmenting and reassembling first by column and then by row. The following separately provides descriptions.

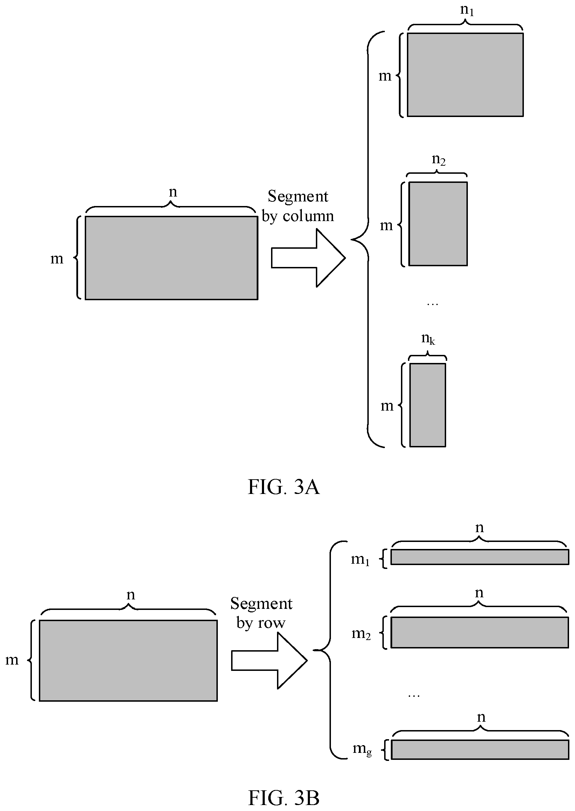

In an implementation, as shown in FIG. 3A, the compression apparatus segments the raw data by column. One data block may be at least one column of data in the raw data. For example, the raw data is data of m rows and n columns. The compression apparatus segments the raw data into k groups of data by column. The 1^{st} group includes n₁ columns of data, the 2^{nd} group includes n₂ columns of data, the others follow the same rule, and the k^{th} group includes nₖ columns of data. Both m and n are integers greater than 1, and k is an integer greater than 1 and less than n.

In another implementation, as shown in FIG. 3B, the compression apparatus segments the raw data by row. One data block may be at least one row of data in the raw data. For example, the raw data is data of m rows and n columns. The compression apparatus segments the raw data into g groups of data by row. A 1^{st} group of data includes m₁ rows of data, a 2^{nd} group of data includes m₂ rows of data, the others follow the same rule, and a g^{th} group of data includes m_{g} rows of data. Both m and n are integers greater than 1, and g is an integer greater than 1 and less than m.

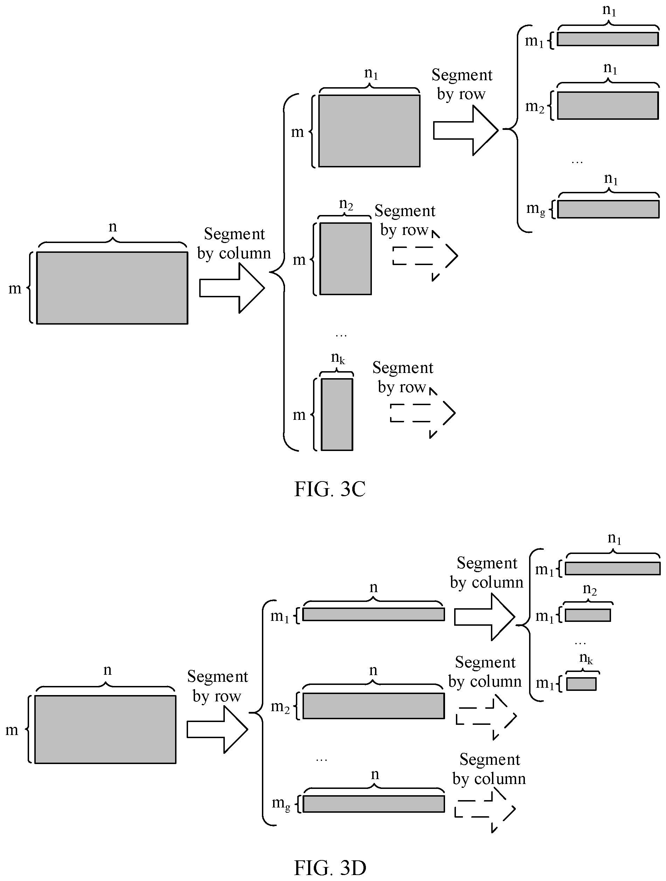

In another implementation, as shown in FIG. 3C, the compression apparatus first segments the raw data by column, and then the compression apparatus segments, by row, at least one group of segmented data obtained through segmentation. For example, the raw data is data of m rows and n columns. The compression apparatus segments the raw data into k groups of data by column. A 1^{st} group of data includes n₁ columns of data, a 2^{nd} group of data includes n₂ columns of data, the others follow the same rule, and a k^{th} group of data includes nₖ columns of data. Both m and n are integers greater than 1, and k is an integer greater than 1 and less than n. Then, the compression apparatus may further segment at least one group of segmented data in the k groups of segmented data by row. The 1^{st} group of segmented data of m rows and n₁ columns is used as an example. The compression apparatus segments the m rows and n₁ columns of data into g groups of data by row. A 1^{st} group of data includes m₁ rows of data, a 2^{nd} group of data includes m₂ rows of data, the others follow the same rule, and a g^{th} group of data includes m_{g} rows of data. Herein, g is an integer greater than 1 and less than m.

In another implementation, as shown in FIG. 3D, the compression apparatus first segments the raw data by row, and then the compression apparatus segments, by column, at least one group of segmented data obtained through segmentation. For example, the raw data is data of m rows and n columns. The compression apparatus segments the raw data into g groups of data by row. A 1^{st} group of data includes m₁ rows of data, a 2^{nd} group of data includes m₂ rows of data, the others follow the same rule, and a g^{th} group of data includes m_{g} rows of data. Both m and n are integers greater than 1, and g is an integer greater than 1 and less than m. Then, the compression apparatus may further segment at least one group of segmented data in the g groups of segmented data by column. The 1^{st} group of segmented data of m₁ rows and n columns is used as an example. The compression apparatus segments the m₁ rows and n columns of data into k groups of data by column. A 1^{st} group of data includes n₁ columns of data, a 2^{nd} group of data includes n₂ columns of data, the others follow the same rule, and a k^{th} group of data includes nₖ columns of data. Herein, k is an integer greater than 1 and less than n.

It should be understood that, the compression apparatus in this application may select, based on the feature information of the raw data, to segment the raw data in any one of the foregoing implementations. When the feature information of the raw data is different, a sequence in which the compression apparatus segments by row or column is not completely the same. The following describes the feature information of the raw data and several implementations in which the compression apparatus determines the segmented data based on the feature information of the raw data.

The feature information of the raw data is used to describe a feature of the raw data. The feature of the raw data may be a feature of one or more rows of data in the raw data, or may be a feature of one or more columns of data in the raw data, or may be a feature of one or more data elements in the raw data. For example, if the raw data is arranged by using a column vector as a basic unit, the feature information of the raw data may reflect a degree of correlation between columns of data in the raw data. For another example, if the raw data is arranged by using a row vector as a basic unit, the feature information of the raw data may reflect a degree of correlation between rows of data in the raw data. For another example, the feature information of the raw data may reflect a degree of correlation between a part of data elements in the raw data and another part of data elements.

Optionally, the feature information of the raw data includes at least one of the following:
physical meaning information of at least one data block included in the raw data, or correlation information between at least two data blocks included in the raw data.

The following separately provides descriptions.

In a possible implementation, the feature information of the raw data includes physical meaning information of at least one data block included in the raw data.

The physical meaning information of the data block indicates a physical meaning of a data element included in the data block in an application scenario. For example, RF map data is used as an example. A physical meaning of a data block may be any one of a pitch angle of arrival, an azimuth angle of arrival, or a time of arrival (that is, a delay).

Specifically, the compression apparatus segments the raw data based on the physical meaning information of the raw data, and outputs a groups of segmented data, where a is an integer greater than 1.

Optionally, data blocks in a same group of segmented data have a same physical meaning, and data blocks in different groups of segmented data have different physical meanings. Optionally, a value of a is equal to a quantity of different physical meanings in the raw data. For example, if the raw data includes three types of data blocks having different physical meanings: at least one data block whose physical meaning is A, at least one data block whose physical meaning is B, and at least one data block whose physical meaning is C, the compression apparatus segments the raw data into three groups of segmented data. One group of segmented data includes all data blocks that are in the raw data and whose physical meanings are A, another group of data includes all data blocks that are in the raw data and whose physical meanings are B, and another group of data includes all data blocks that are in the raw data and whose physical meanings are C.

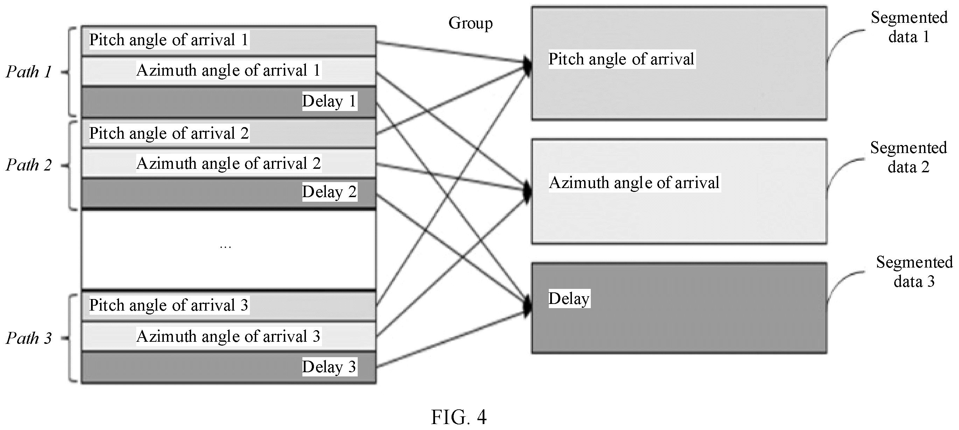

For example, as shown in FIG. 4, RF map data may be segmented into a plurality of columns of data by column. Each column in the RF map data corresponds to ray tracing (ray tracing) data of at least one path (path) of one geographical position, for example, data of a path 1, data of a path 2, and data of a path 3. The data of each path includes pitch angle of arrival data (that is, data whose physical meaning is a pitch angle of arrival), azimuth angle of arrival data (that is, data whose physical meaning is an azimuth angle of arrival), and delay data (that is, data whose physical meaning is a delay). The compression apparatus groups pitch angle of arrival data 1 in the path 1, pitch angle of arrival data 2 in the path 2, and pitch angle of arrival data 3 in the path 3 into one group of segmented data, to obtain segmented data 1. The compression apparatus groups azimuth angle of arrival data 1 in the path 1, azimuth angle of arrival data 2 in the path 2, and azimuth angle of arrival data 3 in the path 3 into one group of segmented data, to obtain segmented data 2. The compression apparatus groups delay 1 data in the path 1, delay 2 data in the path 2, and delay 3 data in the path 3 into one group of segmented data, to obtain segmented data 3. In this example, the compression apparatus groups the data of the three paths into three groups of segmented data based on the physical meanings of the data. Each group of segmented data includes data blocks having one physical meaning, and data blocks included in any two groups of segmented data have different physical meanings.

In this implementation, the feature information of the raw data can reflect which data elements constitute the data blocks in the raw data and what physical meanings these data blocks have. The compression apparatus segments the raw data based on the physical meaning of the raw data. In this way, one group of segmented data includes data of only one physical meaning, and data blocks included in different segmented data have different physical meanings. Data having a same physical meaning is grouped into one group, so that redundant information can be exploited based on the segmented data having the same physical meaning in a subsequent compression process, better compression performance is obtained, and efficiency of subsequent compression is improved. In addition, data blocks included in different segmented data have different physical meanings, so that a compression algorithm that adapts to each piece of segmented data is determined based on respective features of different pieces of segmented data in a subsequent compression process, better compression performance is obtained, and compression efficiency is improved.

In another possible implementation, the feature information of the raw data includes correlation information between at least two data blocks included in the raw data.

The correlation information indicates a degree of correlation or a degree of similarity of data elements included in the at least two data blocks. The degree of correlation or the degree of similarity may be reflected by a feature of a value of a data element included in the data block. For example, a data block is a column vector in the raw data. The degree of correlation between a plurality of data blocks may be represented by using a distance (for example, a Euclidean distance, a mean squared error, a covariance, an L1 distance, or a Wasserstein distance) between a plurality of column vectors. A higher degree of correlation (that is, a stronger correlation) indicates that numerical features of data elements included in a data block are more similar, and it is easier to exploit redundant information. A lower degree of correlation (that is, a weaker correlation) indicates that numerical features of data elements included in a data block are more different, and it is difficult to exploit redundant information.

Specifically, the compression apparatus segments the raw data based on the correlation information of the raw data, and outputs a groups of segmented data, where a is an integer greater than 1. Optionally, after the segmentation, data blocks with a strong correlation are grouped into one group, and data blocks with a weak correlation are grouped into different groups.

For example, point cloud data in a sensing scenario is used as an example. The point cloud data has a strong correlation in time and space. The compression apparatus groups a time-related data block and a space-related data block in the point cloud data into one group. For another example, channel measurement data in a channel measurement scenario is used as an example. The channel measurement data (for example, channel matrix data) has a strong correlation in a frequency domain and a spatial angle domain. The compression apparatus groups a data block related to the frequency domain and a data block related to the spatial angle domain in the channel matrix data into one group.

Optionally, the compression apparatus may determine, based on a clustering algorithm, how to segment the raw data, where the clustering algorithm is used to determine data suitable for being grouped to one group. For example, the compression apparatus configures a clustering sample and a clustering center based on the raw data, and after calculation based on the clustering algorithm, the compression apparatus may output a groups of segmented data. Optionally, a correlation between data blocks in a same group is strong, and a correlation between data blocks in different groups is weak. Optionally, the clustering algorithm may be a k-means clustering algorithm or a spectral clustering algorithm. This is not limited in this application.

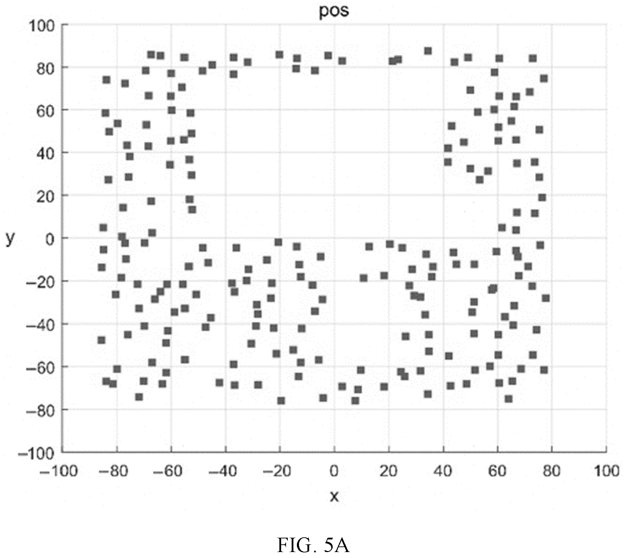

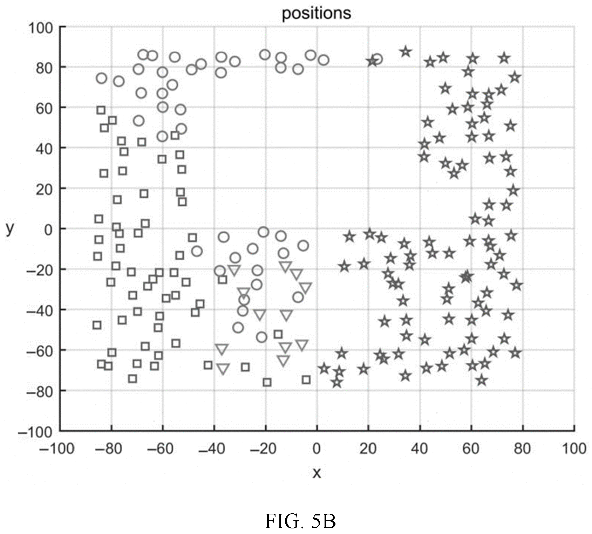

For example, the k-means algorithm is used as an example for description. As shown in FIG. 5A, if the raw data is segmented into n column vectors by column, each point in FIG. 5A is a column vector in the raw data. The compression apparatus uses n column vectors shown in FIG. 5A as clustering samples (namely, n to-be-classified column vectors), and sets at least one clustering center (c_i). A distance (for example, a Euclidean distance, a mean squared error, a covariance, an L1 distance, or a Wasserstein distance) between each clustering sample and the clustering center is calculated based on the k-means algorithm, and then iteration is performed repeatedly to output k categories shown in FIG. 5B. A vector included in a category is a vector included in one piece of segmented data. It should be understood that in actual application, in addition to using one column of data as one clustering sample, one row of data may be used as one clustering sample, or a data block including at least one data element may be used as one clustering sample. This is not limited in this application.

In this implementation, the compression apparatus groups data blocks with a strong correlation in the raw data into one group, and groups data blocks with a weak correlation in the raw data into different groups. Redundant information is more easily exploited between data blocks with a strong correlation. Therefore, the data blocks with a strong correlation are grouped into one group, so that better compressibility is obtained, and efficiency of subsequent compression is improved. In addition, the data blocks with a weak correlation are grouped into different groups, so that a compression algorithm that adapts to each piece of segmented data is determined based on respective features of different pieces of segmented data in a subsequent compression process, better compression performance is obtained, and compression efficiency is improved.

Optionally, in addition to outputting the a groups of segmented data, the compression apparatus may further output first information, where the first information indicates a segmentation manner of segmenting the raw data into the a groups of segmented data.

Optionally, the first information includes first indication information, where the first indication information indicates a position, in the raw data, of a data block included in at least (a-1) groups of segmented data. It may also be understood as that the first indication information indicates a sequence of a plurality of data blocks in the raw data before the raw data is segmented and formats of the plurality of data blocks. In an example, the first indication information indicates a position, in the raw data, of each data block included in the a groups of segmented data. This helps improve reliability of the first indication information. In another example, the first indication information indicates a position, in the raw data, of a data block included in the (a-1) groups of segmented data. Because the compression apparatus segments the raw data into the a groups of segmented data, and one data block is grouped into only one group, when the position, in the raw data, of the data block included in the (a-1) groups of segmented data in the a groups of segmented data is known, a position, in the raw data, of a data block included in a last group of segmented data can be determined. This helps reduce signaling overheads for transmitting the first indication information.

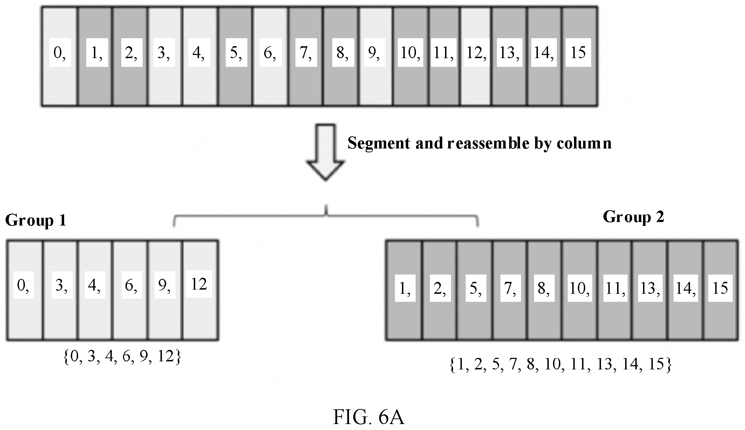

For example, as shown in FIG. 6A, the raw data is arranged into 16 columns of data by column, and a sequence number of each column of data is shown in FIG. 6A. If the compression apparatus segments and reassembles the 16 columns of data into two groups of segmented data, one group of segmented data is {0, 3, 4, 6, 9, 12}, and the other type of segmented data is {1, 2, 5, 7, 8, 10, 11, 13, 14, 15}. The first indication information is sequence numbers of column vectors included in one of the two groups of segmented data. For example, the first indication information indicates that segmented data in a group 1 after the segmentation is {0, 3, 4, 6, 9, 12}. The decompression apparatus can determine, based on the two groups of segmented data and the first indication information, a position, in the raw data, of each column vector in the group 1, and derive a position, in the raw data, of each column vector in a group 2, to restore the two groups of segmented data to the raw data.

Optionally, the first information further includes second indication information, where the second indication information indicates a compression manner of the first indication information.

The second indication information includes any one of the following: a lexicographical order indication, an arithmetic coding indication, a direct indication, or a bit map indication. The following separately provides descriptions.

In an implementation, the second indication information is the lexicographical order indication. The first indication information includes first compression information and second compression information, the first compression information indicates a lexicographical order of numbers of data blocks included in one piece of segmented data, and the second compression information indicates a quantity of data blocks included in one group.

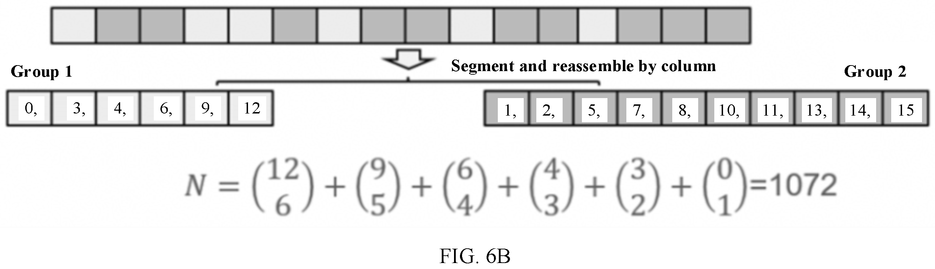

Using FIG. 6B as an example, the raw data shown in FIG. 6A is segmented by column to obtain a group 1 of {0, 3, 4, 6, 9, 12} and a group 2 of {1, 2, 5, 7, 8, 10, 11, 13, 14, 15}. The group 1 includes 6 column vectors selected from the 16 column vectors. By using a combinatorial number system, the group 1 of {0, 3, 4, 6, 9, 12} is mapped to an integer$N = \left(\begin{matrix}12 \\ 6\end{matrix}\right) + \left(\begin{matrix}9 \\ 5\end{matrix}\right) + \left(\begin{matrix}6 \\ 4\end{matrix}\right) + \left(\begin{matrix}3 \\ 2\end{matrix}\right) + \left(\begin{matrix}0 \\ 1\end{matrix}\right) = {C}_{12}^{6} + {C}_{9}^{5} + {C}_{6}^{4} + {C}_{4}^{3} + {C}_{3}^{2} + {C}_{0}^{1} = 924 + 126 + 15 + 4 + 3 + 0 = 1072 ,$ indicating that the group 1 is the 1072^{nd} combination among the 1^{st} to the 8008^{th} (that is, ${C}_{16}^{6}$) combinations obtained through mapping. A total of $\left⌈{log}_{2}\left(8008\right)\right⌉ = 13$ bits are required to represent 1072 in binary mode. The group 1 includes 6 column vectors, represented by 3 bits. In this example, the first indication information includes the first compression information and the second compression information. The first compression information is the digit 1072 indicated by 13 bits, indicating that the combination of sequence numbers of the column vectors in the group 1 is the 1072^{nd} combination among the 1^{st} to the 8008^{th} (that is, ${C}_{16}^{6}$) combinations obtained through mapping; and the second compression information is the digit 6 indicated by 6 bits, indicating that the group 1 includes 6 column vectors.

In this implementation, the first indication information uses lexicographical ordering. Because each numbered group corresponds to a specific combination scheme, a quantity of data blocks in the numbered group is indicated first, followed by the subscript of the combination scheme in the lexicographical order of all combination schemes that select a same quantity of data blocks. This approach uses fewer bits to indicate data blocks included in a group, reducing bit overheads of the first indication information.

In another implementation, the second indication information uses arithmetic coding. That is, a combination number scheme is compressed through arithmetic coding and converted into a binary bit string. Using FIG. 6B as an example, to compress a combination scheme {0, 3, 4, 6, 9, 12}, the 1^{st} element is selected with equal probability from all 16 possible elements, giving probability model p1=1/16. When compressing the 2^{nd} element, both the receive end and the transmit end know that the 1^{st} element is 0 (because arithmetic coding is used at a decoder end for decoding, the decoder end has already decoded the 1^{st} element when decoding the 2^{nd} element). Therefore, the 2^{nd} element is selected with equal probability from the remaining 15 possible elements, giving probability model p2=1/15. Similarly, the 3^{rd} element is selected with equal probability from the remaining 12 elements, giving probability model p3=1/12. The probability model is p4=1/11 for the 4^{th} element, p5=1/9 for the 5^{th} element, and p6=1/6 for the 6^{th} element. In this example, the first indication information is represented by using the foregoing six probability models.

In this implementation, the first indication information is indicated through arithmetic coding, so that fewer bits are used to indicate which data blocks are included in a group, and bit overheads of the first indication information are reduced.

In another implementation, the second indication information is the direct indication. In other words, a group to which each item of the raw data belongs is directly indicated.

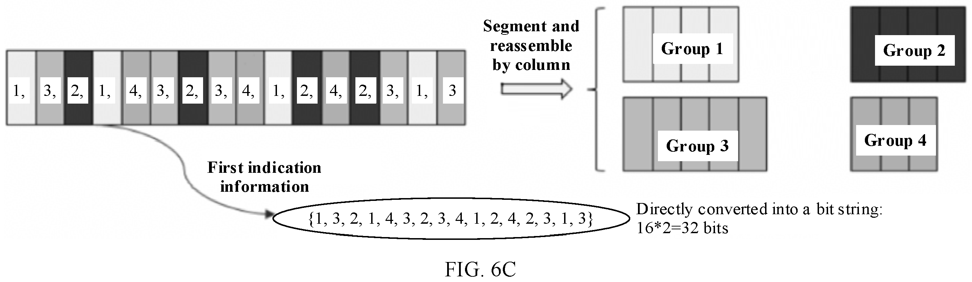

For example, as shown in FIG. 6C, the raw data includes a plurality of columns of data, and data that needs to be grouped into one group is numbered by using one number. If the raw data is segmented into four groups, which are respectively represented by numbers 1, 2, 3, and 4, an arrangement order of a plurality of columns of data in the raw data may be represented as {1, 3, 2, 1, 4, 3, 2, 3, 4, 1, 2, 4, 2, 3, 1, 3} by using the numbers of the groups, and 16*2=32 bits are required for directly converting the raw data into a bit string. In this example, the first indication information represents a set {1, 3, 2, 1, 4, 3, 2, 3, 4, 1, 2, 4, 2, 3, 1, 3} by using 32 bits.

In this implementation, the first indication information is indicated in a direct indication manner, so that a position, in the raw data, of a data block in each group is accurately indicated, and accuracy of data compression is improved.

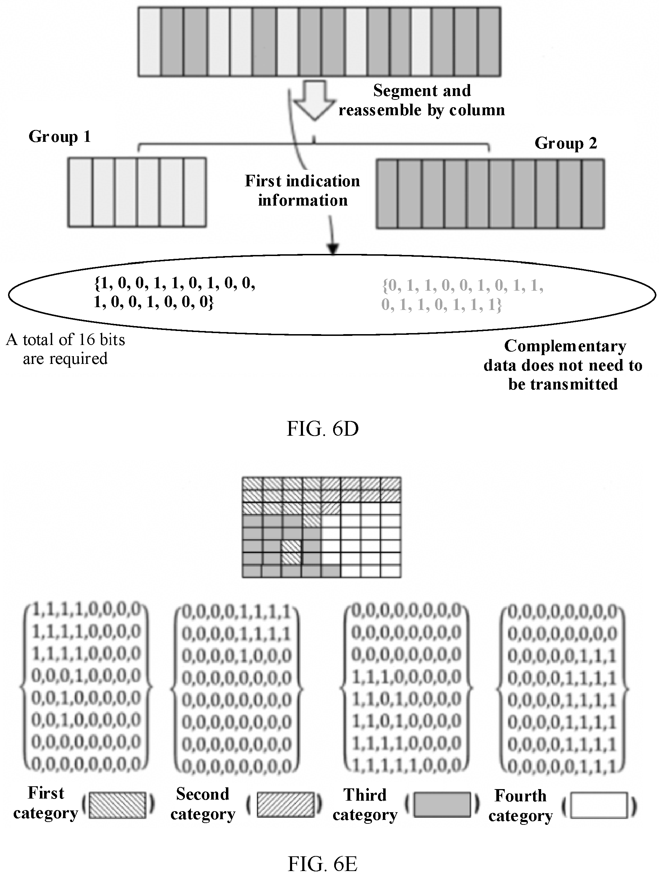

In another implementation, the second indication information is the bit map (bit map) indication. The bit map indication may be a one-dimensional bit map shown in FIG. 6D, or may be a two-dimensional bit map shown in FIG. 6E. This is not limited herein. In the example shown in FIG. 6D, if the raw data is segmented into two groups, 1 may be used to represent one group, and 0 may be used to represent the other group. Based on a position, in the raw data, of each data block in the two groups of segmented data, the first indication information may represent a group {1, 0, 0, 1, 1, 0, 1, 0, 0, 1, 0, 0, 1, 0, 0, 0} by using 16 bits. In the example shown in FIG. 6E, if the raw data is segmented into four groups, four two-dimensional bit maps are used to respectively represent indication information of the four groups, and 1 is used for indication information of each group to indicate a position, in the raw data, of a data element included in the group.

It should be understood that, in actual application, the compression apparatus may determine, based on a feature of the segmented data, to represent the first indication information by using any one of the foregoing manners. This is not limited herein. Optionally, the compression apparatus may select, based on an actual bit length obtained through compression (that is, a data amount obtained through compression), one of the manners to represent the first indication information. For example, the compression apparatus compresses the first indication information in a manner in which a data amount obtained through compression is the smallest. It should be understood that, when the compression apparatus and the decompression apparatus have agreed on a manner in which the first indication information is compressed, the first information may not include the second indication information.

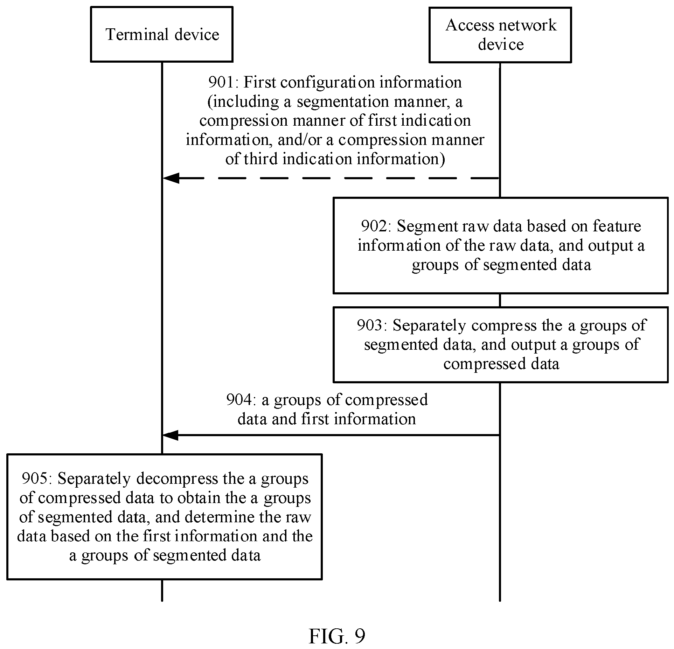

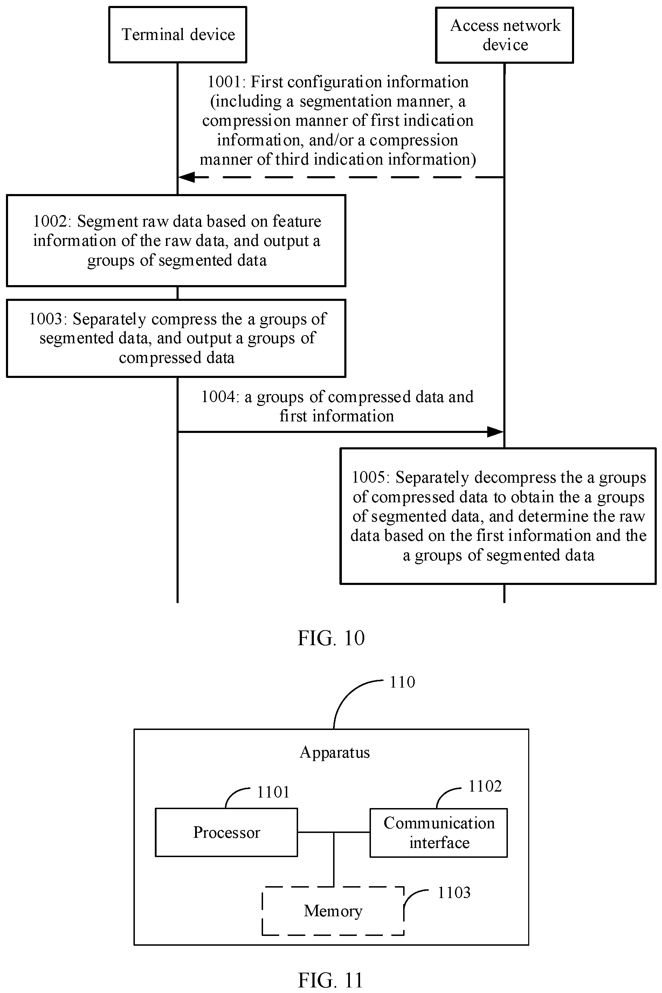

It should be further understood that the compression apparatus may package the second indication information and the first indication information into one information element or one piece of signaling for sending. For example, the first information includes the first indication information and the second indication information, and the compression apparatus sends the first information and a groups of compressed data through one piece of signaling. In addition, the compression apparatus may also separately carry the second indication information and the first indication information in different pieces of signaling for sending. For example, the compression apparatus packages the first indication information and the a groups of compressed data into one piece of signaling for sending, and separately sends the second indication information. For example, the compression apparatus carries the second indication information in configuration signaling as configuration information, and sends, through the configuration signaling, the configuration information together with another parameter related to compression configuration. For descriptions of the configuration information, refer to related descriptions in the following embodiments corresponding to FIG. 9 and FIG. 10. Details are not described herein again.

Optionally, in addition to segmenting the raw data, the compression apparatus may further reorder the raw data. The reordering refers to switching positions of at least two data elements in the at least one data block. Optionally, the data block may be at least one column of data, or may be at least one row of data, or may be a plurality of data elements. This is not limited herein.

Optionally, the compression apparatus may reorder data blocks in the raw data or data blocks in the segmented data. In an example, the reordering is configured before the segmentation. In other words, the compression apparatus first reorders at least two data elements in the raw data based on the feature information of the raw data, and then segments the reordered data. In another example, the reordering is configured after the segmentation. In other words, the compression apparatus first groups the raw data based on the feature information of the raw data, and then reorders at least two data elements in at least one piece of segmented data.

Optionally, the compression apparatus may reorder the at least two data elements in any one of the following manners:

In an implementation, the compression apparatus reorders the at least two data elements in the data block based on a fixed rule. The fixed rule may be sorting the data elements in ascending order, or may be sorting the data elements in descending order, or may be another sorting rule. This is not limited in this application.

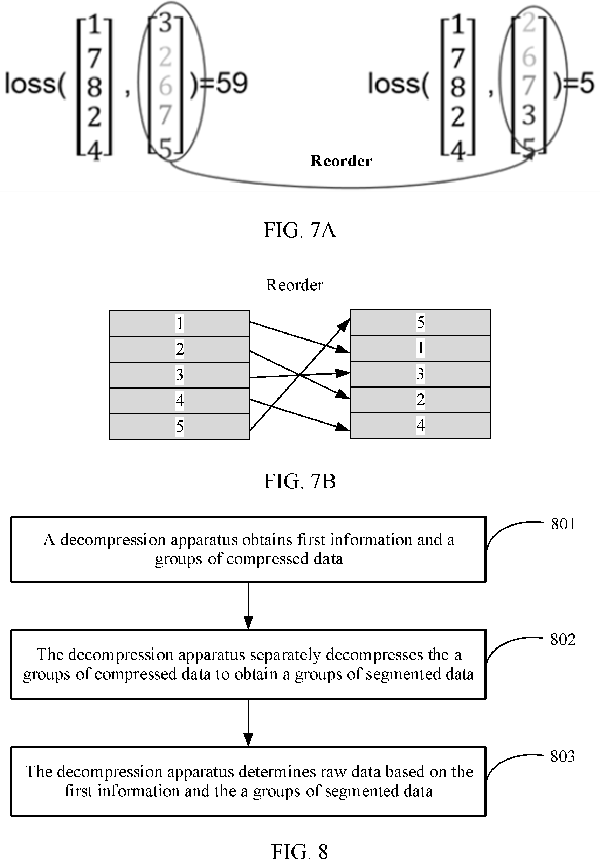

In another implementation, the compression apparatus may determine reordering based on a search algorithm. For example, the compression apparatus reorders one of the two data blocks, and the compression apparatus performs greedy (greedy search) starting from an initial permutation through pairwise exchanging until a permutation method at which a distance no longer decreases is reached. It should be understood that the compression apparatus may further use another search method for searching for an optimal solution to the problem. This is not limited in this application. For example, FIG. 7A shows two columns of data in the raw data or two columns of data in the segmented data. Before the reordering, a distance determined based on a loss function (loss function) is 59, and after the compression apparatus permutes positions of five data elements in a 2^{nd} column of data, a distance determined based on the loss function (loss function) is 5.

In this implementation, after the reordering, a distance between the at least two data blocks (for example, the two columns of data shown in FIG. 7A) can be reduced, and a correlation between the at least two data blocks can be improved, so that joint compression is subsequently performed on the at least two data blocks, and subsequent compression performance is improved.

Optionally, if the compression apparatus performs reordering, the compression apparatus outputs third indication information, where the third indication information indicates a position relationship between the data elements in the data block after the reordering and the data elements in the data block before the reordering. For example, as shown in FIG. 7B, the compression apparatus sequentially marks a plurality of adjacent data elements before the reordering as 1, 2, 3, 4, and 5. After the reordering, an arrangement order of the plurality of data elements is 5, 1, 3, 2, and 4. In this example, the third indication information is a sequence "5, 1, 3, 2, 4", and indicates positions or sequences of the five data elements in the data block before the reordering.

Optionally, the compression apparatus may package the third indication information and the first indication information into one information element or one piece of signaling for sending. For example, the first information includes the first indication information and the third indication information, and the compression apparatus sends the first information and the a groups of compressed data through one piece of signaling. In addition, the compression apparatus may also separately carry the third indication information and the first indication information in different pieces of signaling for sending. For example, the compression apparatus packages the first indication information and the a groups of compressed data into one piece of signaling for sending, and separately sends the third indication information. For example, the compression apparatus carries the third indication information in configuration signaling as configuration information, and sends, through the configuration signaling, the configuration information together with another parameter related to compression configuration. For descriptions of the configuration information, refer to related descriptions in the following embodiments corresponding to FIG. 9 and FIG. 10. Details are not described herein again.

Optionally, the compression apparatus further outputs fourth indication information, where the fourth indication information indicates a compression manner of the third indication information.

Optionally, the fourth indication information includes an arithmetic coding indication or a direct indication. The following separately provides descriptions.

In an implementation, the fourth indication information is the direct indication.

For example, the sequence "5, 1, 3, 2, 4" shown in FIG. 7B is directly converted into a binary bit for representation. In this example, the third indication information is a binary bit, and the binary bit represents the sequence "5, 1, 3, 2, 4".

In another implementation, the fourth indication information is the arithmetic coding indication.

For example, as shown in FIG. 7B, if the sequence "5, 1, 3, 2, 4" is compressed into a bit string through arithmetic coding, probability models used for the arithmetic coding are as follows: P1=1/5 (where a 1^{st} data element is evenly distributed in five possibilities); P2=1/4 (where a 2^{nd} data element is evenly distributed in the remaining four possibilities); P3=1/3 (where a 3^{rd} data element is evenly distributed in the remaining three possibilities); P4=1/2 (where a 4^{th} data element is evenly distributed in the remaining two possibilities); and P1=1 (where a 5^{th} data element is a determined variable). In this example, the third indication information is the sequence "5, 1, 3, 2, 4" represented by the bit string obtained through arithmetic coding.

It should be understood that, in actual application, the compression apparatus may represent the third indication information by using any one of the foregoing manners. This is not limited herein. Optionally, the compression apparatus may select, based on an actual bit length obtained through compression (that is, a data amount obtained through compression), one of the manners to represent the third indication information. For example, the compression apparatus compresses the third indication information in a manner in which a data amount obtained through compression is the smallest. It should be understood that, when the compression apparatus and the decompression apparatus have agreed on a manner in which the third indication information is compressed, the first information may not include the fourth indication information.

It should be further understood that the compression apparatus may package the fourth indication information and the third indication information into one information element or one piece of signaling for sending. For example, the first information includes the third indication information and the fourth indication information, and the compression apparatus sends the first information and the a groups of compressed data through one piece of signaling. In addition, the compression apparatus may also separately carry the fourth indication information and the third indication information in different pieces of signaling for sending. For example, the compression apparatus packages the third indication information and the a groups of compressed data into one piece of signaling for sending, and separately sends the fourth indication information. For example, the compression apparatus carries the fourth indication information in configuration signaling as configuration information, and sends, through the configuration signaling, the configuration information together with another parameter related to compression configuration. For descriptions of the configuration information, refer to related descriptions in the following embodiments corresponding to FIG. 9 and FIG. 10. Details are not described herein again.

In addition, after the compression apparatus segments the raw data into the a groups of segmented data, the compression apparatus performs step 102.

Step 102: The compression apparatus separately compresses the a groups of segmented data, and outputs a groups of compressed data.

In a possible implementation, the compression apparatus may use different compression algorithms for different segmented data, for example, differential compression, transform domain compression, or low rank matrix approximation (low rank matrix approximation, LRMA) compression. This is not limited in this application. For example, one group of segmented data is compressed based on the differential compression algorithm, and another group of segmented data is compressed based on the LRMA compression algorithm.

In this implementation, different compression algorithms are used for different segmented data, so that an appropriate compression algorithm is selected based on a feature of a data element included in each group of segmented data, and compression efficiency is improved.

In another possible implementation, the compression apparatus may use a same compression algorithm for different segmented data, but use different compression parameters. For example, the compression apparatus compresses the a groups of segmented data based on the LRMA compression algorithm, but different rank parameters are used during compression of the groups of data.

In this implementation, different compression parameters are used for different segmented data, so that an appropriate compression parameter is selected based on a feature of a data element included in each group of segmented data, and compression efficiency is improved.

Optionally, after the compression apparatus outputs the a groups of compressed data and the first information, the compression apparatus may send the first information and the a groups of compressed data to the decompression apparatus, so that the decompression apparatus determines the raw data based on the first information and the data blocks in the a groups of segmented data. For details, refer to related descriptions in the embodiment corresponding to FIG. 8. Details are not described herein again.

In this application, the compression apparatus segments the raw data based on the feature information of the raw data, outputs the first information and the a groups of segmented data, and then separately compresses the a groups of segmented data into the a groups of compressed data. Because the raw data is segmented based on the feature information of the raw data, a larger compression ratio is obtained, and transmission resources occupied during transmission are reduced. The first information to be sent to the decompression apparatus is output, so that the decompression apparatus can accurately and efficiently restore the a groups of compressed data to the raw data, and data transmission efficiency is improved. In addition, the compression apparatus performs reordering before compression, and after the reordering, a distance between the at least two data blocks can be reduced, and a correlation between the at least two data blocks can be improved, so that joint compression is subsequently performed on the at least two data blocks, and subsequent compression performance is improved.

The following describes a main procedure of the data decompression method provided in this application with reference to FIG. 8. The data decompression method may be performed by a decompression apparatus. The decompression apparatus may be the apparatus (for example, a communication apparatus like a terminal device or an access network device) or a component (for example, a component like a processor, a chip, or a chip system) of the apparatus described above. The following uses the decompression apparatus as an example for description. As shown in FIG. 8, the data decompression method mainly includes the following steps.

Step 801: The decompression apparatus obtains first information and a groups of compressed data.

Optionally, the compression apparatus sends the first information and the a groups of compressed data to the decompression apparatus. Correspondingly, the decompression apparatus receives the first information and the a groups of compressed data. For example, the compression apparatus is an access network device, and the decompression apparatus is a terminal device. When the access network device has data that needs to be transmitted to the terminal device, the access network device segments and compresses, according to the data compression method shown in FIG. 1, the raw data that needs to be transmitted to the terminal device, and outputs first information and a groups of compressed data. Then, the terminal device receives the first information and the a groups of compressed data from the access network device. For example, the compression apparatus is integrated into a CU, and the decompression apparatus is integrated into a DU. When the CU collects data that needs to be transmitted to the DU, the CU segments and compresses, according to the data compression method shown in FIG. 1, the raw data that needs to be transmitted to the DU, and outputs first information and a groups of compressed data. Then, the DU receives the first information and the a groups of compressed data from the CU. In another application scenario, there is another example in which the decompression apparatus obtains the first information and the a groups of compressed data. Details are not described herein.

The a groups of compressed data are compressed data obtained by the compression apparatus by separately compressing the a groups of segmented data, and a is an integer greater than 1. The a groups of segmented data are data obtained by the compression apparatus by segmenting the raw data.

The first information indicates a segmentation manner of segmenting the raw data into the a groups of segmented data.

Optionally, the first information includes first indication information, where the first indication information indicates a position, in the raw data, of a data block included in at least (a-1) groups of segmented data. Optionally, the first information further includes second indication information, or the decompression apparatus receives second indication information through other signaling. The second indication information indicates a compression manner of the first indication information. For explanations and examples of the first indication information and the second indication information, refer to related descriptions in step 101. Details are not described herein again.

Optionally, the first information further includes third indication information, or the decompression apparatus receives third indication information through other signaling. The third indication information indicates a position relationship between the data elements in the data block after the reordering and the data elements in the data block before the reordering. Optionally, the first information further includes fourth indication information, or the decompression apparatus receives fourth indication information through other signaling. The fourth indication information indicates a compression manner of the third indication information. For explanations and examples of the third indication information and the fourth indication information, refer to related descriptions in step 101. Details are not described herein again.

Step 802: The decompression apparatus separately decompresses the a groups of compressed data, to obtain the a groups of segmented data.

Step 803: The decompression apparatus determines the raw data based on the first information and the a groups of segmented data.

In a possible implementation, the first information includes first indication information, where the first indication information indicates a position, in the raw data, of a data block included in at least (a-1) groups of segmented data. The decompression apparatus determines, based on the first indication information and the a groups of segmented data, a position, in the raw data, of each data block included in the a groups of segmented data, so that the decompression apparatus reassembles the data blocks included in the a groups of segmented data into the raw data.

Using FIG. 6A as an example, the decompression apparatus obtains two groups of segmented data after the decompression. In addition, the decompression apparatus determines, based on the first indication information, that column vectors included in one group of segmented data are {0, 3, 4, 6, 9, 12} and there are a total of 16 column vectors. Therefore, the decompression apparatus can determine that column vectors included in the other group of segmented data are {1, 2, 5, 7, 8, 10, 11, 13, 14, 15}.

Optionally, if the first information further includes the second indication information, or the decompression apparatus receives the second indication information through other signaling, the decompression apparatus decompresses the first indication information based on the second indication information; or if the decompression apparatus does not obtain the second indication information, the decompression apparatus decompresses the first indication information in a default or preconfigured decompression manner. This is not limited in this application. For implementations of the second indication information, refer to related descriptions in step 101. Details are not described herein again.

In another possible implementation, in addition to obtaining the first indication information, the decompression apparatus further obtains third indication information, where the third indication information indicates a position relationship between the data elements in the data block after the reordering and the data elements in the data block before the reordering. The decompression apparatus determines, based on the third indication information, the data block before the reordering, and determines, based on the first indication information, to reassemble the data blocks included in the a groups of segmented data into the raw data.

Optionally, if the first information further includes the fourth indication information, or the decompression apparatus receives the fourth indication information through other signaling, the decompression apparatus decompresses the third indication information based on the fourth indication information; or if the decompression apparatus does not obtain the fourth indication information, the decompression apparatus decompresses the third indication information in a default or preconfigured decompression manner. This is not limited in this application. For implementations of the fourth indication information, refer to related descriptions in step 101. Details are not described herein again.

In this application, the decompression apparatus obtains the a groups of compressed data and the first information, where the first information is used by the decompression apparatus to determine, based on the a groups of segmented data obtained through decompression, the raw data before the segmentation, so that the decompression apparatus restores the a groups of segmented data to the raw data based on the first information. Therefore, even if the compression apparatus performs complex segmentation (and reordering) on the raw data, the decompression apparatus can quickly and efficiently restore the compressed data to the raw data based on the first information, so that data decompression efficiency is improved.

In addition, as shown in FIG. 9 and FIG. 10, this application further provides a data transmission method. The data transmission method is used to resolve a problem that large air interface overheads are occupied when data is transmitted between communication apparatuses.

FIG. 9 describes the data transmission method by using an example in which a compression apparatus is integrated into an access network device and a decompression apparatus is integrated into a terminal device. The data transmission method includes the following steps.

Step 901: The access network device sends first configuration information, and correspondingly, the terminal device receives the first configuration information.

The first configuration information is used to configure information used by the terminal device in a process of determining raw data based on compressed data. The raw data is data that needs to be sent by the access network device to the terminal device, and the compressed data is data generated by the access network device by segmenting and compressing the raw data. Compared with the raw data, the compressed data occupies less transmission resources. It may be understood that the first configuration information is used to configure information used by the decompression apparatus in the terminal device in an inverse process of segmentation.

Optionally, the first configuration information includes a compression type, and the compression type indicates the terminal device to determine which type of decompression is to be performed on the received compressed data. Optionally, the first configuration information includes a basic compression parameter, and the basic compression parameter is a compression parameter that does not change with content of raw data transmitted each time. For example, if a matrix compression algorithm is a low rank matrix approximation LRMA compression algorithm, and matrix data that is determined by the access network device as an input of the matrix compression algorithm has a fixed quantity of rows and a fixed quantity of columns, the basic compression parameter includes the quantity of rows and the quantity of columns.

Optionally, the first configuration information includes a segmentation manner, and the segmentation manner includes any one of the following:
segmenting and reassembling by row, indicating the access network device to segment and reassemble the raw data by row, where a data block in segmented data after the segmentation includes at least one row of data; or
segmenting and reassembling by column, indicating the access network device to segment and reassemble the raw data by column, where a data block in segmented data after the segmentation includes at least one column of data; or
segmenting and reassembling first by row and then by column, indicating the access network device to segment and reassemble the raw data first by row and then by column; or
segmenting and reassembling first by column and then by row, indicating the access network device to segment and reassemble the raw data first by column and then by row.

The segmentation manner is indicated in the first configuration information, so that the terminal device can determine, based on subsequently received first information, whether to reassemble into the raw data by row or by column, and efficiency of the terminal device in a process of restoring the raw data is improved.

Optionally, the first configuration information further includes an indication indicating whether to perform reordering.

Optionally, the first configuration information further includes a compression manner of the first indication information. Optionally, the compression manner of the first indication information includes any one of a lexicographical order indication, an arithmetic coding indication, a direct indication, or a bit map indication described above. For example, the access network device fixedly uses a manner of compressing the first indication information, and indicates the compression manner to the terminal device, so that when the access network device does not carry the second indication information in the first information, the terminal device can still decompress the first indication information based on a received bit stream obtained through compression. This helps simplify content included in the subsequently transmitted first information, reduce air interface overheads for transmitting the first information, and improve data transmission efficiency.

Optionally, the first configuration information further includes a compression manner of the third indication information. Optionally, the compression manner of the third indication information includes the arithmetic coding indication or the direct indication described above. For example, the access network device fixedly uses a manner of compressing the third indication information, and indicates the compression manner to the terminal device, so that when the access network device does not carry the fourth indication information in the first information, the terminal device can still decompress the third indication information based on a received bit stream obtained through compression. This helps simplify content included in the subsequently transmitted first information, reduce air interface overheads for transmitting the first information, and improve data transmission efficiency.

It should be understood that the first configuration information may be carried in radio resource control (radio resource control, RRC) signaling or other higher layer signaling to be configured for the terminal device, or may be dynamically indicated to the terminal device as required through signaling like downlink control information (downlink control information, DCI) or a MAC control element (MAC Control Element, MAC CE). This is not limited in this application.

Step 902: The access network device segments raw data based on feature information of the raw data, and outputs a groups of segmented data.

Step 903: The access network device separately compresses the a groups of segmented data, and outputs a groups of compressed data.

Step 902 and step 903 are similar to step 101 and step 102. For details, refer to related descriptions in step 101 and step 102. Details are not described herein again.

Step 904: The access network device sends the a groups of compressed data and the first information; and correspondingly, the terminal device receives the a groups of compressed data and the first information.

The first information indicates a segmentation manner of segmenting the raw data into the a groups of segmented data.

Optionally, the first information includes first indication information, where the first indication information indicates a position, in the raw data, of a data block included in at least (a-1) groups of segmented data. For explanations and examples of the first indication information, refer to related descriptions in step 101. Details are not described herein again.

Optionally, the first information further includes third indication information, where the third indication information indicates a position relationship between the data elements in the data block after the reordering and the data elements in the data block before the reordering. For explanations and examples of the third indication information, refer to related descriptions in step 101. Details are not described herein again.

Step 905: The terminal device separately decompresses the a groups of compressed data, to obtain the a groups of segmented data, and determines the raw data based on the first information and the a groups of segmented data.

Step 905 is similar to step 802 and step 803. For details, refer to related descriptions in step 802 and step 803. Details are not described herein again.

In this embodiment, the access network device segments and compresses data that needs to be transmitted to the terminal device, and then sends the obtained a groups of compressed data and the first information to the terminal device, so that the terminal device restores the a groups of segmented data obtained through decompression to the raw data based on the first information. The segmentation and the compression can reduce air interface overheads occupied by the access network device to send the compressed data, so that air interface transmission efficiency is improved.

FIG. 10 describes the data transmission method by using an example in which a compression apparatus is integrated into a terminal device and a decompression apparatus is integrated into an access network device. The data transmission method includes the following steps.

Step 1001: The access network device sends second configuration information, and correspondingly, the terminal device receives the second configuration information.

The first configuration information is used to configure information used by the terminal device in a process of determining segmented data and compressed data based on raw data. The raw data is data that needs to be sent by the terminal device to the access network device, and the compressed data is data generated by the terminal device by segmenting and compressing the raw data. Compared with the raw data, the compressed data occupies less transmission resources. It may be understood that the second configuration information is used to configure information used by the compression apparatus in the terminal device in a segmentation process and a compression process.

Optionally, the second configuration information includes a compression type, and the compression type indicates the terminal device to determine which type of compression to be performed on the raw data. Optionally, the second configuration information includes a basic compression parameter, and the basic compression parameter is a compression parameter that does not change with content of raw data transmitted each time. For example, if a matrix compression algorithm is a low rank matrix approximation LRMA compression algorithm, the access network device may configure a fixed quantity of rows and a fixed quantity of columns for the terminal device, so that the terminal device uses matrix data of a fixed size as an input of the matrix compression algorithm during compression.

Optionally, the first configuration information includes a segmentation manner, and the segmentation manner includes any one of the following:
segmenting and reassembling by row, indicating the terminal device to segment and reassemble the raw data by row, where a data block in segmented data after the segmentation includes at least one row of data; or
segmenting and reassembling by column, indicating the terminal device to segment and reassemble the raw data by column, where a data block in segmented data after the segmentation includes at least one column of data; or
segmenting and reassembling first by row and then by column, indicating the terminal device to segment and reassemble the raw data first by row and then by column; or
segmenting and reassembling first by column and then by row, indicating the terminal device to segment and reassemble the raw data first by column and then by row.

The segmentation manner is indicated in the second configuration information, so that the access network device can determine, based on subsequently received first information, whether to reassemble into the raw data by row or by column, and efficiency of the access network device in a process of restoring the raw data is improved.

Optionally, the second configuration information further includes an indication indicating whether to perform reordering, indicating whether the terminal device performs reordering when processing the raw data.

Optionally, the second configuration information further includes a compression manner of the first indication information. Optionally, the compression manner of the first indication information includes any one of a lexicographical order indication, an arithmetic coding indication, a direct indication, or a bit map indication described above. For example, the access network device indicates the terminal device to fixedly use a manner of compressing the first indication information, and indicates the compression manner to the terminal device, so that when the access network device does not carry the second indication information in the first information, the access network device can still decompress the first indication information based on a received bit stream obtained through compression. This helps simplify content included in the subsequently transmitted first information, reduce air interface overheads for transmitting the first information, and improve data transmission efficiency.

Optionally, the second configuration information further includes a compression manner of the third indication information. Optionally, the compression manner of the third indication information includes the arithmetic coding indication or the direct indication described above. For example, the access network device indicates the terminal device to fixedly use a manner of compressing the third indication information, and indicates the compression manner to the terminal device, so that when the access network device does not carry the fourth indication information in the first information, the access network device can still decompress the third indication information based on a received bit stream obtained through compression. This helps simplify content included in the subsequently transmitted first information, reduce air interface overheads for transmitting the first information, and improve data transmission efficiency.

It should be understood that the second configuration information may be carried in RRC signaling or other higher layer signaling to be configured for the terminal device, or may be dynamically indicated to the terminal device as required through signaling like DCI or a MAC CE. This is not limited in this application.

Step 1002: The terminal device segments raw data based on feature information of the raw data, and outputs a groups of segmented data.

Step 1003: The terminal device separately compresses the a groups of segmented data, and outputs a groups of compressed data.

Step 1004: The terminal device sends the a groups of compressed data and the first information; and correspondingly, the access network device receives the a groups of compressed data and the first information.

Step 1005: The terminal device separately decompresses the a groups of compressed data, to obtain the a groups of segmented data, and determines the raw data based on the first information and the a groups of segmented data.

In this embodiment, step 1002 to step 1005 are similar to step 902 to step 905. For details, refer to related descriptions in step 902 to step 905. Details are not described herein again.

In this embodiment, the terminal device segments and compresses data that needs to be transmitted to the access network device, and then sends the a groups of compressed data and the first information to the access network device, so that the access network device restores the a groups of segmented data obtained through decompression to the raw data based on the first information. The segmentation and the compression can reduce air interface overheads occupied by the terminal device to send the compressed data, so that air interface transmission efficiency is improved.

Corresponding to the solutions provided in the foregoing method embodiments, an embodiment of this application further provides a corresponding apparatus (for example, a communication apparatus). The apparatus includes a corresponding module or unit configured to perform each part in the foregoing embodiments. The module or unit may be software, hardware, or a combination of software and hardware. The following only briefly describes the apparatus and system. For implementation details of the solutions, refer to descriptions in the foregoing method embodiments. Details are not described below again.

FIG. 11 is a diagram of a structure of an apparatus 110 according to embodiment. It should be understood that the compression apparatus in the method embodiment corresponding to FIG. 1 or the decompression apparatus in the method embodiment corresponding to FIG. 8 may be based on the structure of the apparatus 110 shown in FIG. 11 in this embodiment. As shown in FIG. 11, the apparatus 110 includes a processor 1101. Optionally, the apparatus 110 may further include a memory 1103 and a communication interface 1102. The processor 1101 is coupled to the memory 1103, and the processor 1101 is coupled to the communication interface 1102.

The communication interface 1102 is connected to another apparatus through a communication link. For example, the communication interface 1102 may include an interface between the apparatus 110 and another apparatus. For example, if the apparatus 110 is a compression apparatus, the communication interface 1102 may be an interface between the apparatus 110 and a decompression apparatus. For another example, if the apparatus 110 is a decompression apparatus, the communication interface 1102 may be an interface between the apparatus 110 and a compression apparatus.

The processor 1101 may be a central processing unit (central processing unit, CPU), an application-specific integrated circuit (application-specific integrated circuit, ASIC), a programmable logic device (programmable logic device, PLD), or a combination thereof. The PLD may be a complex programmable logic device (complex programmable logic device, CPLD), a field programmable logic gate array (field programmable gate array, FPGA), a generic array logic (generic array logic, GAL), or any combination thereof. The processor 1101 may be one processor, or may include a plurality of processors. This is not specifically limited herein.

In addition, the memory 1103 is mainly configured to store a software program and data. The memory 1103 may exist independently, and is connected to the processor 1101. Optionally, the memory 1103 and the processor 1101 may be integrated, for example, integrated into one or more chips. The memory 1103 can store program code for executing the technical solutions in embodiments of this application, and the processor 1101 controls the execution. Various types of executed computer program code may also be considered as drivers of the processor 1101. The memory 1103 may include a volatile memory (volatile memory), for example, a random-access memory (random-access memory, RAM). The memory may alternatively include a non-volatile memory (non-volatile memory), for example, a read-only memory (read-only memory, ROM), a flash memory (flash memory), a hard disk drive (hard disk drive, HDD), or a solid-state drive (solid-state drive, SSD). The memory 1103 may alternatively include a combination of the foregoing types of memories. The memory 1103 may be one memory, or may include a plurality of memories. For example, the memory 1103 is configured to store various data, for example, the first information. For details, refer to related descriptions in the foregoing embodiments. Details are not described herein again.

In a design, the apparatus 110 is configured to perform the method of the compression apparatus in the embodiment corresponding to FIG. 1. The processor 1101 is configured to segment raw data based on feature information of the raw data, and output first information and a groups of segmented data. Each group of segmented data includes at least one data block, data blocks included in any two groups of segmented data are different, the first information indicates a segmentation manner of segmenting the raw data into the a groups of segmented data, and a is an integer greater than 1. Then, the processor 1101 is configured to: separately compress the a groups of segmented data, and output a groups of compressed data.

Optionally, the feature information of the raw data includes at least one of the following: correlation information between at least two data blocks included in the raw data, or physical meaning information of at least one data block included in the raw data.

Optionally, data blocks in a same group of segmented data have a same physical meaning, and data blocks in different groups of segmented data have different physical meanings.

In a possible implementation, the communication interface 1102 is configured to send the first information and the a groups of compressed data to the decompression apparatus.

Optionally, the first information includes first indication information, where the first indication information indicates a position, in the raw data, of a data block included in at least (a-1) groups of segmented data. Optionally, the first information further includes second indication information, or the communication interface 1102 sends second indication information, where the second indication information indicates a compression manner of the first indication information. Optionally, the second indication information includes any one of the following: a lexicographical order indication, an arithmetic coding indication, a direct indication, or a bit map indication.

In a possible implementation, the second indication information includes the lexicographical order indication, the first indication information includes first compression information and second compression information, the first compression information indicates a lexicographical order of numbers of data blocks included in one piece of segmented data, and the second compression information indicates a quantity of data blocks included in one group.

In a possible implementation, the processor 1101 is further configured to: reorder a plurality of data elements in at least one data block, and output at least one data block after the reordering.

Optionally, the first information further includes third indication information, or the communication interface 1102 sends third indication information, where the third indication information indicates a position relationship between the data elements in the data block after the reordering and the data elements in the data block before the reordering.

Optionally, the first information further includes fourth indication information, or the communication interface 1102 sends fourth indication information, where the fourth indication information indicates a compression manner of the third indication information.

Optionally, the fourth indication information includes either one of the following: an arithmetic coding indication or a direct indication.

It should be noted that for specific implementations and beneficial effect of this embodiment, refer to the method of the compression apparatus in the foregoing embodiment. Details are not described herein again.

In another design, the apparatus 110 is configured to perform the method of the decompression apparatus in the embodiment corresponding to FIG. 8. The communication interface 1102 is configured to obtain first information and a groups of compressed data, where a is an integer greater than 1. The processor 1101 is configured to: separately decompress the a groups of compressed data, to obtain a groups of segmented data, where each group of segmented data includes at least one data block, and data blocks included in any two groups of segmented data are different; and determine raw data based on the first information and the a groups of segmented data, where the first information indicates a segmentation manner of segmenting the raw data into the a groups of segmented data.

In a possible implementation, the first information includes first indication information, where the first indication information indicates a position, in the raw data, of a data block included in at least (a-1) groups of segmented data. Optionally, the first information further includes second indication information, or the communication interface 1102 receives second indication information, where the second indication information indicates a compression manner of the first indication information. Optionally, the second indication information includes any one of the following: a lexicographical order indication, an arithmetic coding indication, a direct indication, or a bit map indication.

In a possible implementation, the second indication information includes the lexicographical order indication, the first indication information includes first compression information and second compression information, the first compression information indicates a lexicographical order of numbers of data blocks included in one piece of segmented data, and the second compression information indicates a quantity of data blocks included in one group.

In a possible implementation, the first information further includes third indication information, or the communication interface 1102 receives third indication information, where the third indication information indicates a position relationship between the data elements in the data block after the reordering and the data elements in the data block before the reordering. The processor 1101 is further configured to determine, based on the third indication information, the data block before the reordering.

In a possible implementation, the first information further includes fourth indication information, or the communication interface 1102 receives fourth indication information, where the fourth indication information indicates a compression manner of the third indication information. Optionally, the fourth indication information includes either one of the following: an arithmetic coding indication or a direct indication.

In a possible implementation, the segmented data is data obtained by segmenting the raw data based on feature information of the raw data; and the feature information of the raw data includes at least one of the following: correlation information between at least two data blocks included in the raw data, or physical meaning information of at least one data block included in the raw data.

In a possible implementation, data blocks in a same group of segmented data have a same physical meaning, and data blocks in different groups of segmented data have different physical meanings.

It should be noted that for specific implementations and beneficial effect of this embodiment, refer to the method of the decompression apparatus in the foregoing embodiment. Details are not described herein again.

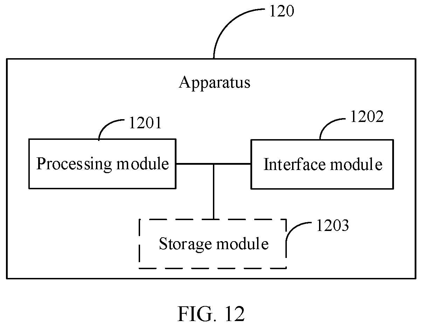

As shown in FIG. 12, this application further provides an apparatus 120. The apparatus 120 may be a compression apparatus, or may be a decompression apparatus. If the apparatus 120 is used in a communication system, the apparatus 120 may be integrated into a communication apparatus. The communication apparatus may be a terminal device or an access network device, or may be a component (for example, an integrated circuit or a chip) of the terminal device or the access network device. For example, in the embodiment shown in FIG. 9, the compression apparatus is integrated into the access network device, and the decompression apparatus is integrated into the terminal device. For another example, in the embodiment shown in FIG. 10, the compression apparatus is integrated into the terminal device, and the decompression apparatus is integrated into the access network device.

The apparatus 120 may include a processing module 1201 (or referred to as a processing unit), and optionally, may further include an interface module 1202 (or referred to as a transceiver unit or a transceiver module) and a storage module 1203 (or referred to as a storage unit). The interface module 1202 is configured to implement communication with another device. The interface module 1202 may be, for example, a transceiver module or an input/output module.

In a possible design, one or more modules in FIG. 12 may be implemented by one or more processors, or may be implemented by one or more processors and memories, or may be implemented by one or more processors and transceivers, or may be implemented by one or more processors, memories, and transceivers. This is not limited in embodiments of this application. The processor, the memory, and the transceiver may be disposed separately or may be integrated.

The apparatus 120 has a function of implementing the compression apparatus described in embodiments of this application. For example, the apparatus 120 includes a corresponding module, unit, or means (means) for the compression apparatus to perform the steps related to the compression apparatus described in embodiments of this application. The function, unit, or means (means) may be implemented by software or hardware, may be implemented by hardware executing corresponding software, or may be implemented by a combination of software and hardware. For details, further refer to corresponding descriptions in the method embodiment corresponding to FIG. 1. Details are not described herein again.

Alternatively, the apparatus 120 has a function of implementing the decompression apparatus described in embodiments of this application. For example, the apparatus 120 includes a corresponding module, unit, or means (means) for the decompression apparatus to perform the steps related to the decompression apparatus described in embodiments of this application. The function, unit, or means (means) may be implemented by software or hardware, may be implemented by hardware executing corresponding software, or may be implemented by a combination of software and hardware. For details, further refer to corresponding descriptions in the method embodiment corresponding to FIG. 8.

In addition, this application provides a computer program product. The computer program product includes one or more computer instructions. When the computer program instructions are loaded and executed on a computer, the procedures or functions according to embodiments of this application are all or partially generated. For example, the method related to the compression apparatus in FIG. 1 is implemented. For another example, the method related to the decompression apparatus in FIG. 8 is implemented. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk drive, or a magnetic tape), an optical medium (for example, a digital versatile disc (digital versatile disc, DVD)), a semiconductor medium (for example, a solid-state drive (solid-state drive, SSD)), or the like.

In addition, this application further provides a computer-readable storage medium. The storage medium stores a computer program, and the computer program is executed by a processor to implement the method related to the compression apparatus in FIG. 1.

In addition, this application further provides a computer-readable storage medium. The storage medium stores a computer program, and the computer program is executed by a processor to implement the method related to the decompression apparatus in FIG. 8.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

## Claims

1. A data compression method, comprising:
segmenting raw data based on feature information of the raw data, and outputting first information and a groups of segmented data, wherein each group of segmented data comprises at least one data block, data blocks comprised in any two groups of segmented data are different, the first information comprises a segmentation manner indicating to segment the raw data into the a groups of segmented data, and a is an integer greater than 1; and
separately compressing the a groups of segmented data, and outputting a groups of compressed data.

2. The method according to claim 1, wherein the feature information of the raw data comprises at least one of the following:
correlation information between at least two data blocks comprised in the raw data, or physical meaning information of at least one data block comprised in the raw data.

3. The method according to claim 2, wherein data blocks in a same group of segmented data have a same physical meaning, and data blocks in different groups of segmented data have different physical meanings.

4. The method according to any one of claims 1 to 3, wherein the method further comprises:
sending the first information and the a groups of compressed data.

5. The method according to claim 4, wherein the first information comprises first indication information, and the first indication information indicates a position, in the raw data, of a data block comprised in at least (a-1) groups of segmented data.

6. The method according to claim 5, wherein the method further comprises:
sending second indication information, wherein the second indication information indicates a compression manner of the first indication information.

7. The method according to claim 6, wherein the second indication information comprises any one of the following:
a lexicographical order indication, an arithmetic coding indication, a direct indication, or a bit map indication.

8. The method according to claim 7, wherein the second indication information comprises the lexicographical order indication, the first indication information comprises first compression information and second compression information, the first compression information indicates a lexicographical order of numbers of data blocks comprised in one piece of segmented data, and the second compression information indicates a quantity of data blocks comprised in one group.

9. The method according to any one of claims 1 to 8, wherein the data block comprises a plurality of data elements; and
the method further comprises:
reordering a plurality of data elements in at least one data block, and outputting at least one data block after the reordering.

10. The method according to claim 9, wherein the method further comprises:
sending third indication information, wherein the third indication information indicates a position relationship between the data elements in the data block after the reordering and the data elements in the data block before the reordering.

11. The method according to claim 10, wherein the method further comprises:
sending fourth indication information, wherein the fourth indication information indicates a compression manner of the third indication information.

12. The method according to claim 11, wherein the fourth indication information comprises either one of the following:
an arithmetic coding indication or a direct indication.

13. The method according to any one of claims 5 to 12, wherein the segmentation manner comprises any one of the following:
segmenting and reassembling by row; or
segmenting and reassembling by column; or
segmenting and reassembling first by row and then by column; or
segmenting and reassembling first by column and then by row.

14. A data decompression method, comprising:
obtaining first information and a groups of compressed data, wherein a is an integer greater than 1;
separately decompressing the a groups of compressed data, to obtain a groups of segmented data, wherein each group of segmented data comprises at least one data block, and data blocks comprised in any two groups of segmented data are different; and
determining the raw data based on the first information and the a groups of segmented data, wherein the first information indicates a segmentation manner of segmenting the raw data into the a groups of segmented data.

15. The method according to claim 14, wherein the first information comprises first indication information, and the first indication information indicates a position, in the raw data, of a data block comprised in at least (a-1) groups of segmented data.

16. The method according to claim 15, wherein the method further comprises:
obtaining second indication information, wherein the second indication information indicates a compression manner of the first indication information.

17. The method according to claim 16, wherein the second indication information comprises any one of the following:
a lexicographical order indication, an arithmetic coding indication, a direct indication, or a bit map indication.

18. The method according to claim 17, wherein the second indication information comprises the lexicographical order indication, the first indication information comprises first compression information and second compression information, the first compression information indicates a lexicographical order of numbers of data blocks comprised in one piece of segmented data, and the second compression information indicates a quantity of data blocks comprised in one group.

19. The method according to any one of claims 14 to 18, wherein the data block comprises a plurality of data elements; and
the method further comprises:
obtaining third indication information, wherein the third indication information indicates a position relationship between the data elements in the data block after the reordering and the data elements in the data block before the reordering; and
determining, based on the third indication information, the data block before the reordering.

20. The method according to claim 19, wherein the method further comprises:
obtaining fourth indication information, wherein the fourth indication information indicates a compression manner of the third indication information.

21. The method according to claim 20, wherein the fourth indication information comprises either one of the following:
an arithmetic coding indication or a direct indication.

22. The method according to any one of claims 14 to 21, wherein the segmentation manner comprises any one of the following:
segmenting and reassembling by row; or
segmenting and reassembling by column; or
segmenting and reassembling first by row and then by column; or
segmenting and reassembling first by column and then by row.

23. The method according to any one of claims 14 to 22, wherein the segmented data is data obtained by segmenting the raw data based on feature information of the raw data; and
the feature information of the raw data comprises at least one of the following:
correlation information between at least two data blocks comprised in the raw data, or physical meaning information of at least one data block comprised in the raw data.

24. The method according to claim 23, wherein data blocks in a same group of segmented data have a same physical meaning, and data blocks in different groups of segmented data have different physical meanings.

25. An apparatus, wherein the apparatus comprises a module configured to perform the method according to any one of claims 1 to 13, or comprises a module configured to perform the method according to any one of claims 14 to 24.

26. An apparatus, comprising a processor, wherein the processor is configured to perform the method according to any one of claims 1 to 13, or is configured to perform the method according to any one of claims 14 to 24.

27. A computer-readable storage medium, wherein the computer-readable storage medium stores instructions, and when the instructions are run on a computer, the computer is enabled to perform the method according to any one of claims 1 to 13, or perform the method according to any one of claims 14 to 24.
